Europäisches Patentamt

European Patent Office

Office européen des brevets

(19)

(11)  EP 0 837 966 B1

(12)  **EUROPEAN PATENT SPECIFICATION**

(45) Date of publication and mention
     of the grant of the patent:
     **05.02.2003   Bulletin 2003/06**

(21) Application number: **97917309.3**

(22) Date of filing: **14.04.1997**

(51) Int Cl.[7]: **D21F 1/06**

(86) International application number:
     **PCT/FI97/00226**

(87) International publication number:
     **WO 97/039182 (23.10.1997 Gazette 1997/45)**

(54) **METHOD FOR OVERALL REGULATION OF THE HEADBOX AND/OR THE FORMER OF A PAPER MACHINE OR EQUIVALENT**

VERFAHREN ZUR STAUFFAUFLAUF- UND/ODER FORMERGESAMTREGELUNG EINER PAPIERMASCHINE ODER DERGLEICHEN

PROCEDE CONTINU DE REGULATION GENERALE DE LA CAISSE DE TETE ET/OU DU FORMEUR D'UNE MACHINE A PAPIER OU A CARTON

(84) Designated Contracting States:
     **AT DE FI FR GB IT SE**

(30) Priority: **18.04.1996  US 634465**
              **14.03.1997  US 818837**

(43) Date of publication of application:
     **29.04.1998   Bulletin 1998/18**

(73) Proprietor: **Metso Paper, Inc.**
     **00130 Helsinki (FI)**

(72) Inventors:
     • HUOVILA, Jyrki
       **FIN-40950 Muurame (FI)**
     • HÄMÄLÄINEN, Jari
       **FIN-40420 Jyväskylä (FI)**
     • NYBERG, Petri
       **FIN-40520 Jyväskylä (FI)**

     • **PAKARINEN, Pekka**
       **FIN-40340 Jyväskylä (FI)**

(74) Representative: **Herttuainen, Mauri et al**
     **Forssén & Salomaa Oy**
     **Yrjönkatu 30**
     **00100 Helsinki (FI)**

(56) References cited:
     • **ICIAM/GAMM 95: APPLIED SCIENCES,
       ESPECIALLY MECHANICS, MINISYMPOSIA
       CONTRIBUTIONS, Hamburg, 3-7 July 1995,
       Edited by E. KREUZER and O. MAHRENHOLTZ,
       Berlin: Akademie Vlg, 1996; & (ZEITSCHRIFT
       FUER ANGEWANDTE MATHEMATIK UND
       MECHANIK, 0044-2267; 76: Suppl. 4) pages
       65-68, (Haemaelaeinen J., TIIHONEN T.,
       Modelling and Simulation of Fluid Flows in a
       Paper Machine Headbox).**

**Description**

The invention concerns a method for continuous overall regulation of the single-layer or multi-layer headbox and/or the former of a paper, board or pulp-draining machine.

In the following, when a paper machine and papermaking technology are spoken of, it should be emphasized that it is considered that these notions and, at the same time, the scope of the invention also include the manufacture of board and, where applicable, also pulp machines.

In a way known from the prior art, out of the slice opening of the headbox of a paper or board machine, a pulp suspension jet is fed onto the forming wire or into the gap between the wires. As is known from the prior art, the instrumentation of the headbox consists of machine controls and of quality and grade regulations, which include, in respect of the operation of the headbox, regulations of the levels, flow rates and pressures at the short-circulation pumps, sorters, de-aerators, and equalizing tanks, controls of the valves of recirculation flows, dilution feeds and edge flow feeds, etc., as well as controls of the actuators of the headbox, which controls regulate, e.g., the geometry and the cross-direction profile of the slice channel.

As is known from the prior art, as a rule, each individual actuator in the headbox has an analogical or digital regulator of its own, which receives its set value from the operator or from an optimal regulator operating in respect of some quality or grade quantity. As an example of an optimal regulator can be mentioned the prior-art basis weight regulation system of a paper machine, which system is usually based on profiling of the shape of the slice opening or of the supply of dilution fluid. By means of optimal regulators of the basis weight profile, attempts are made to compensate especially for the shape of the basis weight profile which is measured at the final end of the dryer section and which arises when water, fillers and fibers are removed out of the paper web in the former and in the press section possibly unevenly in the cross direction, when the web is stretched in the machine direction while shrinking in the cross direction during drying of the paper, but also faults in the pulp jet arising in or before the headbox may be compensated for.

From the prior art, a system for the control of the top slice bar at the headbox of a paper machine is known, which system comprises a bevel-gear stepping-motor actuator, by whose means the slice-regulating top slice bar is controlled by means of regulation spindles attached to the bar at a spacing of about 7...15 cm, said spindles being displaced by means of said actuator provided at their opposite ends. As a rule, the profiling of the top slice bar of the slice opening takes place so that each regulation gear is controlled separately by means of a successive sequence of treatment. In order that the positioning could be carried out with the required precision of about 10 μm, an electronic system for measurement of the locations of the regulation spindles is also needed. In the way known from the prior art, the top slice bar can be controlled by means of an optimal system of regulation of the basis weight, which system is, according to the prior art, a response regulator based on the measured location and shape of unit response. Even though, by means of this system of regulation based on the top slice bar, it is possible to affect the basis weight profile efficiently, a change in the geometry of the slice opening also has a great effect on the flow field in the jet, in particular on the velocity components in the cross direction and in the machine direction, which is commonly not taken into account in the prior-art regulators. The flow field determines the directions of the fibers (fiber orientation) in the structure of the paper, which again affects the anisotropic behaviour of the strength and the deformation potential of paper.

As is known from the prior art, in papermaking technology, a pulp suspension jet is fed out of the slice opening of the headbox onto the forming wire of the former part or into the gap between wires. Formers known from the prior art are fourdrinier formers and twin-wire formers. The twin-wire formers can be divided further into gap formers and hybrid formers. In gap formers the pulp suspension jet discharged from the headbox is fed directly into the forming gap between the forming wires, and in hybrid formers, before the twin-wire portion of the forming zone, a single-wire initial portion is used.

The scope of the method of the present invention includes various forming parts or formers of paper machines. Recently, however, twin-wire formers have largely replaced the single-wire fourdrinier formers, and the advantages and the objectives of the method of the present invention are accomplished to the greatest extent expressly in twin-wire formers.

In the formers of paper machines, a number of different forming members are employed. The principal objective of these members is to produce a compression pressure and pressure pulsation in the fibrous layer that is being formed, by means of which pressure and pulsation the draining of water out of the web that is being formed is promoted and, at the same time, the formation of the web is improved. Said forming members include various forming shoes, which are usually provided with a curved ribbed deck and over which the forming wires placed one above the other and the web placed between the wires are curved. In the area of these forming shoes, water is drained through the wire placed at the side of the outside curve by the effect of its tightening pressure, and this draining of water is aided further by a field of centrifugal force. Draining of water also takes place through the wire placed at the side of the inside curve, which draining is, as a rule, enhanced by means of a vacuum present in a chamber in the forming shoe. The ribbed deck of the forming shoe produces said pressure pulsation, which both promotes the dewatering and improves the formation of the web. Further, the prior-art forming members include what is called loading-element units, through which two wires placed one opposite to the other run as a straight or curved run. In the prior-art loading-element units, inside the loop of one of the wires there is a pressure loading unit, and inside the loop of the opposite wire, a dewatering unit provided with a set of guide and dewatering ribs has been fitted. As is known from the prior art, said loading-element unit is, as a rule, placed on the fourdrinier wire portion so that the loading-element unit is preceded by a single-wire portion of considerable length, in which portion a substantial amount of draining of water takes place before the web runs as a straight run in the plane of the fourdrinier wire through the loading-element unit.

With respect to the patent literature related to the present invention, reference is made, by way of example, to the following papers: *EP-0541457 A1, US-3,666,621, US-4,374,703, US-4,500,968, US-4,680,089, US-4,707,779, US-4,748,400*, and *US-5,071,514.*

Regarding the applicant's recent patents concerning systems of regulation of the headbox, reference is made to the *FI Patents 81,848 (equiv. to EP-0408894 A3) and 85,731 (equiv. to EP-401188* and *US-5,381,341).*

In said *FI Patent 85, 731,* a system of regulation of a paper machine is described in which its various actuators are provided with intelligent actuator controllers, and the data communication between a control device higher in the regulation hierarchy and the various actuator controllers has been arranged along a path common of the different actuator controllers, and the different actuator controllers are connected to the system of measurement and computing of the profiling of the web produced by means of the paper machine through a serial bus provided with a network server.

The article: ICIAM/GAMM 95: applied sciences, especially mechanics, minisymposia contributions, Hamburg, 3-7 July 1995; edited by E. Kreuzer and O. Mahrenholtz; Berlin: Akademie Vlg, 1996, (Zeitschrift für angewandte Mathematik und Mechanik, 0044-2267; 76: Suppl. 4) pages 65-68 (Hämäläinen J., Tiihonen T.; Modelling and simulation of fluid flows in a paper machine head box) seems to be the closest prior art to our invention.

The article shows modelling and simulation of fluid flows in a paper machine head box in order to optimise the geometry of the head box. A flow model has been developed based on the geometry of the head box. Numerical solutions of the flow model are calculated in order to determine the optimal shape of a component in a head box. Numerical results of the flow model have been compared to measured velocity profiles and pressure profiles in a pilot machine. As the correlation was good it is stated that the model is accurate enough to be used in analysing global profiles in slice channel flows.

The optimal shape of the back wall of the header in the head box has been calculated as an example. The boundary condition has been that the velocity profile of the flow coming from the header is uniform in the cross direction of the machine. This means that a two-dimensional model can be used.

The article discloses thus a method for modelling the flows within the head box in order to be able to design the geometry of the head box in an optimal way. The cost function in the article is only related to simulated and desired velocities of the outflow boundary of the header of the head box. This means that the geometry of a head box can be optimised during the construction of the head box by using this model, but the model is not aimed at actually controlling the head box.

The general object of the present invention is further development of the prior art so that, by means of a paper machine, paper of better quality properties can be produced more economically. As is well known, for example because of new printing methods, the quality requirements imposed on paper become constantly stricter and the requirements imposed on the economy of a paper machine become ever higher. As is well known, in a papermaking process the headbox and the former component which have an entirely decisive role and whose operation largely determines the quality properties of the paper. Later compensation for "defects" produced in the paper in the headbox and the former are often not even possible, and this compensation, for example regulation of various cross-direction profiles, is quite complicated and results in expenses, for example, in the form of various investments in equipment, their operation and maintenance.

A starting point of the present investment has been the constant increase in the computing and data processing capacity of computers and the lowering of the cost of said capacity so that, for example in the regulation of a paper machine, it is possible to introduce novel applications which were fully impossible earlier because of limitations of the capacity of computers and/or because of the cost of said capacity.

Besides on the above increased computing and data processing capacity and reduced costs of computers, the present invention is partially also based on mapping work carried out by the applicant recently in the field of the flows and draining of paper stock suspension.

It is a non-indispensable further object of the invention to provide a system of regulation of formers by whose means it is possible to make changes of paper grades taking place in a paper machine substantially quicker. As is known from the prior art, a change of paper grade takes a considerable period of time, typically from ten minutes to hours, which has a substantial effect on the operating time ratio and on the overall efficiency of the paper machine.

One starting point of the present invention has been the theoretical research work taking place both by the applicant and in different research institutes and universities, with regard to which reference is made to the *Doctoral Thesis "Mathematical Modelling and Simulation of Fluid Flows in the Headbox of Paper Machines"* by Mr. Jari Hämäläinen, Ph.D., one of the inventors of the present patent application, University of Jyväskylä, Department of Mathematics, Report 57, Jyväskylä 1993. In the following, a quotation will be made from the beginning of said Doctoral Thesis as a background for the present invention.

"The pulp and paper industry is constantly challenged by complex and contradictory problems of how to produce higher quality paper from lower quality pulp at increased speeds and reduced production costs. Today, the situation is further complicated by introduction of recycled fiber in the papermaking furnish.

Present day paper machine technology has been achieved mostly through experimental work in pilot plants. With increasing speeds and sophistication of modern papermaking, this approach has become too expensive and time consuming, so that more effective ways must be found to carry out further development of this technology. One such method is mathematical modelling and numerical simulation. Well known fluid flow models and numerical methods have been available for many years but only in the last few years has the development of supercomputers rendered the use of computational fluid dynamics in practical and industrial applications possible.

Fluid flow phenomena in a paper machine headbox establishes a number of important paper properties, chief of which are basis weight and fiber orientation profiles in the three principal directions. The shape of the headbox internal flow passages and the turbulence they generate are of utmost importance. It is possible to study these phenomena through mathematical modelling of the fluid flow.

Turbulence is a desirable flow phenomenon, as it contributes to fiber dispersion by breaking down fiber flocks and preventing new ones from forming. The problem is how to model turbulence. Although a general fluid flow model, the Navier-Stokes equations, exists, the execution of direct numerical simulation of these equations for turbulent flows is practically impossible. This is because a mesh of finite element approximation should consist of an order of $10^9$ grid points which even today's supercomputers are not fast enough to handle, nor do they have enough memory capacity. Because of practical importance of turbulence, a number of models containing empirical laws have been developed. The most widely used model and one which has also been used in this work, is the k-$\epsilon$ model. "

In view of achieving the objectives stated above and those that will come out later, the invention is mainly characterized by claim 1.

The system of regulation of the headbox of a paper machine that applies the method of the present invention is based on a physical model starting from equations of fluid dynamics. The physical flow equations of the system of regulation are solved in the geometry of the headbox that is being regulated on the basis of the boundary conditions given by measurements of the headbox, said headbox geometry consisting of the shapes of the flow faces, such as walls that can be bent and the top slice bar. These boundary conditions may include measurements of the static pressure at different locations in the flow duct in the headbox, measurements of the flow rates and flow velocities in different ducts, such as the approach pipe, dilution feeds and edge flow feeds, measurements of the basis weight profiles and fibre orientation profiles measured in the paper web. These measurements are arranged so that the boundary conditions necessary for a solution of the flow equations can be determined unequivocally by means of the measurements. The solving of the flow equations is carried out by means of a computer of high computing capacity by using numerical solution methods, such as known finite element methods (FEM) and finite difference methods (FDM). By using the solvable physical flow model fixed by initial values and boundary conditions, the new, optimal flow conditions in relation to the pre-determined cost function are predicted. This is carried out by means of known methods of optimizing. The control set point values determined by the optimal flow conditions are set to the actuator of the headbox, such as the slice bar or flow faces profilers, the flow valve actuators and the speed regulators of the pumps. This procedure is repeated within a time period which is short enough to ensure the quality of produced paper.

The continuous system of regulation of the headbox of a paper machine that applies the method of the present invention has sufficiently accurate knowledge of the flow state of the headbox based on the physical flow model, which is solved by making use of the data on the geometry of the headbox and of other initial and boundary conditions necessary for the solution of the flow model. The system of regulation that applies the invention seeks the best possible regulation and set values for the instrumentation devices and actuators of the headbox in relation to the given cost function. The cost function to be optimized is, as a solution of the flow model, the difference between the flow state obtained on the basis of measurements of quality of the paper, of the state and measurements of the instrumentation and of the costs of operation and the target flow state that meets the requirements of quality and costs. The target flow state is determined by means of the requirements of quality of the paper, which requirements depend on the flows in the headbox, and, if necessary, also by means of the costs of operation of the headbox.

The system of regulation that makes use of the method of the present invention knows the effects of the regulation quantities on the flow state of the headbox and, thus, also on the flow state of the slice jet on the basis of the physical flow model. Thus, the system of regulation finds the best possible regulation and set values by means of optimizing and flow computing, as a rule, without experimentally established responses or without having to slow down or to attenuate the system of regulation of the headbox by means of long time constants and low amplification coefficients, which is necessary in the prior-art regulation systems. The optimal change computed by means of the flow model includes the overall changes produced by the operations of the actuators in the flow state in the headbox. In such a case, the change taking place as a result of optimizing is far more reliable than in the prior-art systems of regulation, and as a result of this, an optimal change can be carried out as a single operation. This makes the reaching of optimal quality considerably quicker in paper grade and other changes and reduces the overall costs.

The flow model of a headbox is based on the basic laws of fluid dynamics, i.e. on conservation laws (mass, momentum, energy, angular momentum) or on simplified equations derived from same, whose numerical solution is possible by means of a computer of sufficiently high capacity. The initial and boundary conditions of the flow model are on-line or laboratory measurements and information provided by the operator, for example, concerning the runnability and costs.

As the basis of the flow model it is possible to use the headbox model developed by the applicant, which model consists of models of the header, the equalizing chamber and of the slice channel. By means of said models, it is possible to simulate the flow velocities, the static pressure, and the turbulence quantities. If it is desirable to simulate changes and profiles of consistency, equations for fiber consistency are needed. Such equations are known from the prior art, such as from the model suggested by Morten Steen in his Doctoral Thesis for the accumulation and destruction of fiber flocks, but it is a drawback of said model that the flow velocity field is not affected by the changes in consistency. A flow model that may possibly be applied in the present invention is a multi-phase model which takes into account the reactions of the flow field to changes in consistency by means of interactions of the different phases (water, fibers, fillers, etc.).

In addition to the headbox flow model, in the present invention a transfer model is needed, which determines the relationship between the jet discharged out of the slice opening of the headbox and the finished paper, among other things depending on the jet/wire ratio, because the measurements of basis weight and fiber orientation are made from the paper, whereas the headbox flow model calculates the flow up to the slice jet only. The transfer model must also include information between the location in the system of coordinates in the headbox and the location of the quality quantity measured from finished paper. Such a transfer model is known in itself, and it is used, for example, by the applicant in the prior-art headbox regulation systems.

The fixing of the parameters in the flow model of a headbox to be applied in the present invention must be carried out specifically for each machine, and if the flow model includes an equation for consistency, the fixing must also be carried out specifically for the paper grade in respect of each paper grade to be produced. In such a case, both direct measurements from the headbox and measurements carried out from the paper are required.

The direct measurements are utilized for fixing the headbox model. All measurements that are economically possible in practice are welcome, but it is easiest to measure static pressures from a number of different positions in the headbox. Flow velocities do not have to be measured, but the velocity profiles needed for the flow model must be known otherwise. In particular, it is necessary to know the velocity profile in the headbox approach pipe. It can be made known, for example, by making the intake profile resistance invariable by means of a perforated plate. Further, data on the flow rates in the headbox are needed, such as the overall flow rate, the recirculation, and the edge feed flow rates.

The interdependence between the slice jet provided by the headbox flow model and the paper produced out of said jet is fixed by means of measurements carried out from dried paper. If the velocity of the slice jet is measured, for example, in connection with the starting of the paper machine, this measurement is utilized for verification both of the headbox flow model and of said transfer model.

For the purpose of fixing the flow model, it is necessary to know the geometry of the headbox in detail, also under pressure during operation, in order that the flow model should simulate the flows in the correct geometry. Of course, it is advisable to carry out verification measurements from the jet or from paper, either during the starting of a flow-model based regulator or, for example, on-line constantly during operation of the machine. However, according to the present-day prior art, the flow-field models that have been developed, with their various parameters, are already sufficiently good to predict properties of paper so reliably that they can be used in optimal regulation in accordance with the present invention.

In the flow model itself, as adaptable and variable parameters needed by the model remain exclusively parameters dependent on the flowing material, such as consistencies, viscosities, fiber and filler compositions and parameters that represent interactions of the different phases, etc. If these parameters vary within narrow limits only, they can also be fixed. For them, it is possible to make a model of their own, which is based on possible simple measurements of, for example, temperature and consistency etc. which can be integrated in the process, or said information is requested from the operator.

The fixing of the transfer model to be fitted between a flow model and the quality properties of paper depends on what measurements can be carried out by means of the measurement devices of the paper machine on-line or in the laboratory. On-line profile measurement of basis weight and formation have been included in the prior art for a long time. Currently, the fiber orientation profile is measured as a routine operation in the laboratory of the paper mill, from where the data can be transferred to the use of the regulation system, for example, by means of a local network.

From the basis weight profile, information is obtained for regulation of the consistency profile, the formation measurement reports on the turbulence level in the flow and on the fiber-flock interactions. From the fiber orientation, a direct response is obtained concerning the velocity field in the jet, and conventional regulators based on such a transfer model are in operation. In the flow model, the information obtained from the fiber orientation can be used for verification of the geometry data and of measurements in particular in respect of the shapes of the top slice bar of the headbox and of the header as well as, for example, in respect of the flow measurements of edge flow feeds. As a particularly important feature should be mentioned that, when a contradiction arises between the prediction given by the flow model and the quality measurements of paper, the headbox is most likely to be contaminated so that the contamination starts interfering with the operation of the headbox. In this way a clear indicator or diagnostic system can be produced as to when the runnability and the quality have deteriorated to such an extent that the paper machine should be run down for the purpose of washing.

An optimal regulator based on a flow model gives set values to sub-regulators, such as to those PI or PID regulators that take care of the control of individual actuators, such as valves of additional-feed pipes or spindles of the top slice bar, on the basis of flow measurement, position or location measurement, etc. An optimal regulator based on a flow model may simulate the flow state either on the basis of set values or directly based on measurement. The optimal regulator may take care of failure reporting if some actuator or regulator cannot reach the set value.

In order that the methods of optimization could be employed in the method of regulation in accordance with the present invention, the whole of this method step of the invention must be formulated in the form of an assignment of mathematical optimization. In such a case, what is required is a model as accurate as possible for the physical phenomenon concerned, regulation quantities by whose means the optimum is sought, as well as the cost function that is minimized or maximized. In the invention, the regulation quantities may be, for example, dilution profile of the pulp suspension, slice-opening profile, recirculation and edge feed flows. The regulation profiles must be given by means of a few parameters; for example, the regulation values of the top slice bar are given by means of the spacing of its spindles. The searching of optimal regulation values is carried out by means of a general optimizing method, such as in the commonly known OSD (Optimal Shape Design) assignments, for example, by means of quasi-Newton's methods.

Said cost function comprises at least the target profiles of finished paper (basis weight and orientation), but additionally it may also include components related to runnability and/or to consumption of energy. For example, if a certain quality level is set for the paper, it is possible to seek the lowest possible recirculation so that the required quality level (and cost level) are achieved. Different weights are used for different costs; for example, the quality of the paper is adopted as the most important factor, and/or, if the runnability can be improved and/or energy be saved without deteriorating the quality, this is carried out by means of the method of regulation of the present invention. If quality quantities are added to the cost function to be optimized, they must be indicated by means of the velocity profiles and the turbulence of the jet, i.e., in practice, the jet discharged out of the slice opening is optimized.

In accordance with the invention it is possible to accomplish a system of optimization of the regulation parameters of the former part of a paper machine. This system is based on a mapping of the draining process that produces the structure of the paper that is being dewatered, in particular of the flow field of said process, by means of a physical model. Above this model in the system of regulation in accordance with the present invention, an optimizing system of regulation operates, by whose means all of the regulation parameters of the former part are regulated by means of overall regulation, such as the vacuum levels of the forming rolls, loading-element boxes, forming shoes, and/or vacuum flatboxes, the positions of the forming rolls and/or forming ribs, and or loading forces and/or positions of the water-draining elements, tensions of the forming wires, and/or retention and its profiling, as well as other parameters that affect the web formation and the draining of water taking place out of the web in the former.

The method of regulation in accordance with the invention does not necessarily require any direct measurements in the wire part.

It is a substantial advantage of the invention that, based on the model that is applied, in real time, the system of regulation of the invention based on the physical model "knows" what is taking place in the wire part and what is the state of operation of the wire part. Further, the model that is applied in the invention "predicts" what will take place within the wire and what kind of a fiber mesh is being formed. Thus, by means of the model-based regulation in accordance with the invention, it is possible to enhance the control of paper quality and the operation of the former and to reduce the costs of operation continuously and as an overall control and regulation.

In particular in situations of change of grade in a paper machine, the present invention provides the advantage that by means of the model it is possible to predict new optimal regulation values for the future situation, i.e. for the paper grade to be run next. In this way the time taken by the change of grade can be reduced decisively, and the operating time ratio and the overall efficiency of the paper machine can be increased substantially.

If necessary, in connection with the present invention, it is possible to apply direct measurement of retention, or alternatively the retention is obtained from the model that is applied in the present invention.

As a rule, the present invention is applied most advantageously so that the cross-direction profiles of the paper web, such as the basis weight profiles and the fiber orientation profiles, are controlled by means of the headbox by making use of conventional systems of regulation of the headbox and/or of regulation by means of dilution and/or, particularly favourably, by making use of the overall system of regulation of the headbox based on mapping and described. However, the scope of the invention does not exclude embodiments in which cross-direction profiling of the web, such as profiling of water draining pressure and/or of retention, is also carried out by means of the former while, if necessary, also making use of the system of regulation in accordance with the present invention and of the optimization carried out by said system.

The system of regulation of the former of a paper machine that applies the method of the present invention is based on a physical model starting in particular from equations of fluid dynamics. The physical flow equations of the model and possible other, corresponding equations are solved in the geometry of the former that is being regulated on the basis of the boundary conditions given by the measurements. Further, the data on the state of the flow coming from the headbox to the former (velocity, consistency, turbulence) are required. For fixing of the parameters of the model, if necessary, measurements of the draining of water in the former and basis weight profiles and fiber orientation profiles measured in the paper web are utilized. These data are arranged so that the boundary conditions necessary for a solution of the model formed by the flow equations and equivalent can be determined unequivocally. The solving of the flow equations and equivalent is carried out by means of a computer of high computing capacity by using numerical solution methods, such as known finite element methods (FEM) and finite difference methods (FDM). By means of the solvable physical flow model fixed by initial values and boundary conditions, the new regulation values optimal in relation to the pre-determined cost function are predicted. This is carried out by means of known methods of optimizing. The control set point values determined by the computed optimal flow conditions are set to the necessary actuators of the former, such as the actuators that regulate the vacuums in the suction rolls and/or suction boxes and the wire tensions. This procedure is repeated with a time period which is short enough to ensure the quality of produced paper in consideration of the circumstances.

The continuous system of regulation of the former of a paper machine that applies the method of the present invention has sufficiently accurate knowledge of the state of the former, in particular of the flow state, based on the physical model, which is solved by making use of the data on the geometry of the former and of other initial and boundary conditions necessary for the solution of the model. The system of regulation that applies the invention seeks the best possible regulation and set values for the actuators of the former in relation to the given cost function.

Also the flow model of a former is based on the basic laws of fluid dynamics, i.e. on conservation laws (mass, momentum, energy, angular momentum) or on simplified equations derived from same, whose numerical solution is possible by means of a computer of sufficiently high capacity. The initial and boundary conditions of the flow model are on-line or laboratory measurements and information provided by the operator, for example, concerning the runnability and costs.

As the basis of the flow model it is possible to use a multi-phase model, in which there is a law of conservation of momentum and mass for each phase (water, fibers, fillers, air) as well as interaction terms for the transfer of the momentum between the different phases.

In addition to the former flow model, in the present invention a transfer model is needed, which determines the relationship between the formed web after the former and the finished paper, depending on the operation of the press section and the dryer section and of possible finishing devices, if any. Such a transfer model is known in itself, and it is used, for example, by the applicant in the prior-art headbox regulation systems.

The fixing of the parameters in the flow model of a former to be applied in the present invention must be carried out specifically for each machine and specifically for each paper grade to be produced. In such a case, both direct measurements from the former, such as measurements of draining of water, and measurements carried out from the paper are required. The direct measurements are utilized for fixing the former model. All measurements that are economically possible in practice are, as a rule, useful, but it is easiest to measure draining of water from a number of different positions in the former. Further, it is necessary to know the state of the flow fed from the headbox to the former.

The interdependence between the web provided by the former flow model and the finished paper is fixed by means of measurements carried out from dried paper.

For the purpose of fixing the flow model, it is necessary to know the geometry of the former part (rolls, shoes) and the flow coming from the headbox, in order that the flow model should simulate the flows in the correct geometry. As a rule, it is advisable to carry out verification measurements from the slice jet or from the paper, either during the starting of a flow-model based regulator or on-line constantly during operation of the machine.

From the basis weight profile, information is obtained for regulation of the consistency profile, and the formation measurement reports on the turbulence level in the flow and on the fiber-flock interactions.

An optimal regulator based on a flow model gives set values to sub-regulators, such as to those PI or PID regulators that take care of the control of individual actuators, such as the control of vacuum levels and wire tension, if necessary, based on measurements of pressure and wire tension.

In order that the methods of optimization could be employed in the method of regulation in accordance with the present invention, the whole of this method step of the invention must be formulated in the form of an assignment of mathematical optimization. In such a case, what is required is a model as accurate as possible for the physical phenomenon concerned, regulation quantities by whose means the optimum is sought, as well as the cost function that is minimized or maximized. In the invention, the regulation quantities may be, for example, vacuum levels, loadings of the water-draining members etc, such as positions of forming members. The searching of optimal regulation values is carried out by means of a general optimizing method, such as in the commonly known assignments of optimization of shape and regulation (Optimal Shape Design), for example, by means of quasi-Newton's methods.

Said cost function comprises at least the target properties of finished paper (formation and orientation level), but additionally it may also include components related to runnability and/or to consumption of energy. For example, if a certain quality level is set for the paper, it is possible to seek the lowest possible wire tension so that the required quality level (and cost level) are achieved and the wear of the wire is reduced. Different weights are used for different costs; for example, the quality of the paper is adopted as the most important factor, and/or, if the runnability can be improved and/or energy be saved without deteriorating the quality, this is carried out by means of the method of regulation of the present invention.

The efficiency of numerical flow computing and optimization have a direct effect on how quickly the regulation system can react to changes in the running situation. Therefore, in the present invention, both advanced numerical algorithms and high capacity of computers are required in order that the regulation of the headbox and/or the former by means of the flow model should be sufficiently rapid in practice. If necessary, the numerical computing can be accelerated by means of a number of techniques. The optimization is based on changes in the cost function (partial derivatives) in relation to the regulation quantities. Sensitivities in respect of each regulation quantity can be assumed to be independent from one another, in which case they can be computed in parallel by means of computers of several processors. The computing that is being carried out by each processor can be enhanced, for example, by means of the perturbation theory. A sensitivity analysis can be carried out in an environment of a linearized solution so that the flow model is solved by means of the perturbation theory (a sort of linearization). Even if the perturbation theory is not absolutely accurate for a non-linear flow model, it, however, predicts a change in the cost function in the correct direction, which is sufficient in the computing of the gradient of the cost function.

The sensitivity of a cost function in relation to the regulation quantities can also be solved by numerically solving a so-called adjoint state equation. Besides the solver of the flow model, this technique also requires a solver of the adjoint state equation. When the gradient (sensitivity) has been computed, elsewhere a real non-linear model is used for optimizing, in which case the optimizing proper is based on the real flow model, and inaccuracies produced by the perturbation theory or by the solution of the adjoint state equation are not seen in the final result of the optimization.

Said parallel computing can be used both in the optimization in the way described above and in numerical solution of the flow model. For example, in the finite-element method the numerical integration is carried out over every element, and at this stage information is not needed concerning the surrounding elements.

Further, if the flow model of the headbox and/or the former consists of a number of sub-models, the sub-models can be solved at the same time, and in between data are updated between the different processors (sub-models) depending on the solutions of the sub-models. The computing can also be enhanced by dividing the optimization into parts. Certain regulation quantities are likely to have a greater effect on the quality of paper than others, in which case the most important parameters are optimized more frequently while reacting to the changes quickly, while other parameters are optimized less frequently.

An optimal regulation of the sort described above can be carried out while making use of a flow model also with some instructible model, such as a neuro-network, or with some other statistical model. In such a case, the physical flow model is solved in said geometry with several different initial and boundary conditions in advance, and with these results, for example, a statistical model can be adapted or instructed for the flow state of the headbox/former and/or for the dependence of the cost function in respect of each individual headbox/former, its flow geometry or flow properties.

In the following, an exemplifying embodiment of the invention and an environment of application of same will be described in detail with reference to the illustrations in the figures in the accompanying drawing, the invention being in no way strictly confined to the details of said illustrations.

Figure 1 is a schematic illustration of a single-layer headbox with its most important measurement and regulation devices and flow quantities.

Figure 2 shows the same as Fig. 1, to which illustration the measurement and regulation quantities and the necessary indications of coordinates applicable to a single-layer headbox of the present invention have been added.

Figure 3 is a schematic vertical sectional view of a two-layer headbox given as an environment of application of the invention.

Figure 4 is an illustration similar to Fig. 3 of a three-layer headbox given as an environment of application of the invention, and said headbox may also be a headbox in accordance with the applicant's Patent Application *FI-933030 (equivalent to EP Appl. 94850116 and equivalent to US Pat. Appl. 08/269348).*

Figure 5 illustrates a system of regulation that makes use of the method of the present invention as a block diagram.

Figure 6 is a schematic illustration, as an environment of application of the invention, of a former with its most important regulation devices and quantities.

Figure 7 illustrates a system of regulation that makes use of the method of the present invention as a block diagram of principle.

Figure 8 illustrates a mode of carrying out of a stage of optimizing included in the method of the invention as a flow diagram.

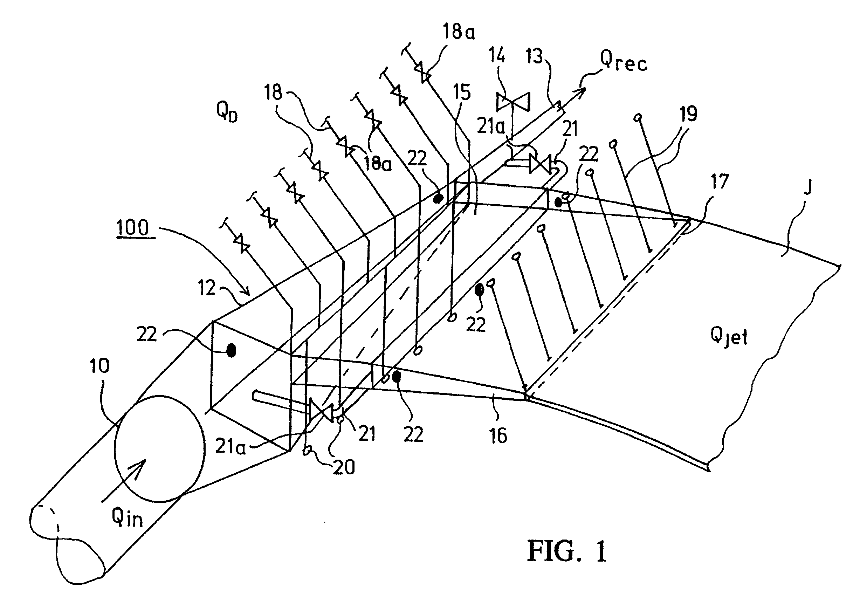

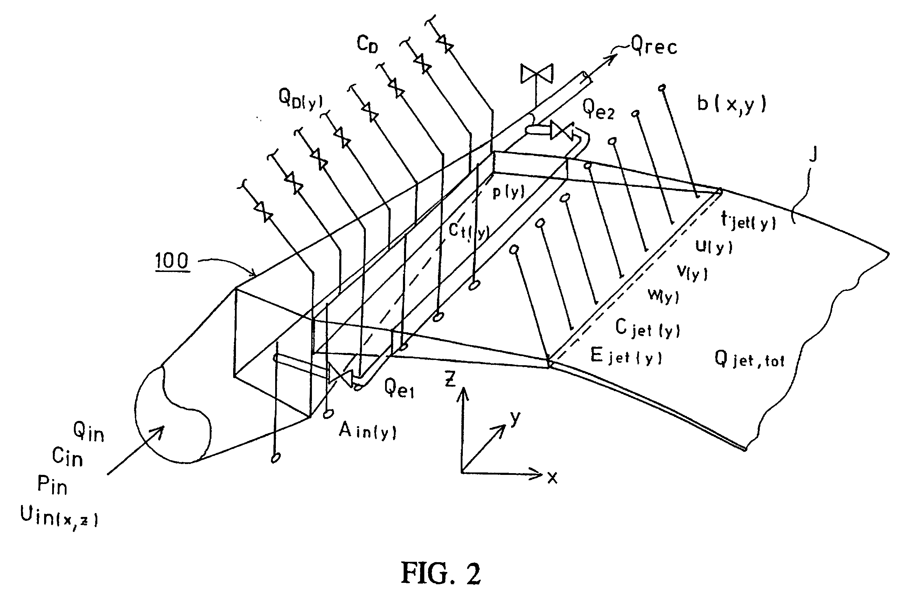

Figs. 1 and 2 illustrate a single-layer headbox 100 of a paper machine, which comprises an approach pipe 10 for the paper stock suspension flow $Q_{in}$, which pipe is connected with the header 12 of the headbox. As is well known, the header 12 becomes narrower in the flow direction y of the stock suspension. The end of the header 12 opposite to the approach pipe 10 communicates with a recirculation pipe 13, whose flow rate $Q_{rec}$ is measured. The recirculation flow $Q_{rec}$ is regulated by means of the regulation valve 14. The front wall of the header 12 is connected with the turbulence generator 15, which comprises one or two successive tube batteries.

When two tube batteries are used, there may be an equalizing chamber (not shown) in itself known between said batteries. The downstream side of the turbulence generator 15 is connected to the slice channel 16, which becomes narrower in the flow direction x and out of whose slice opening 17 the pulp suspension jet J is discharged onto the forming wire or into the forming gap between two wires.

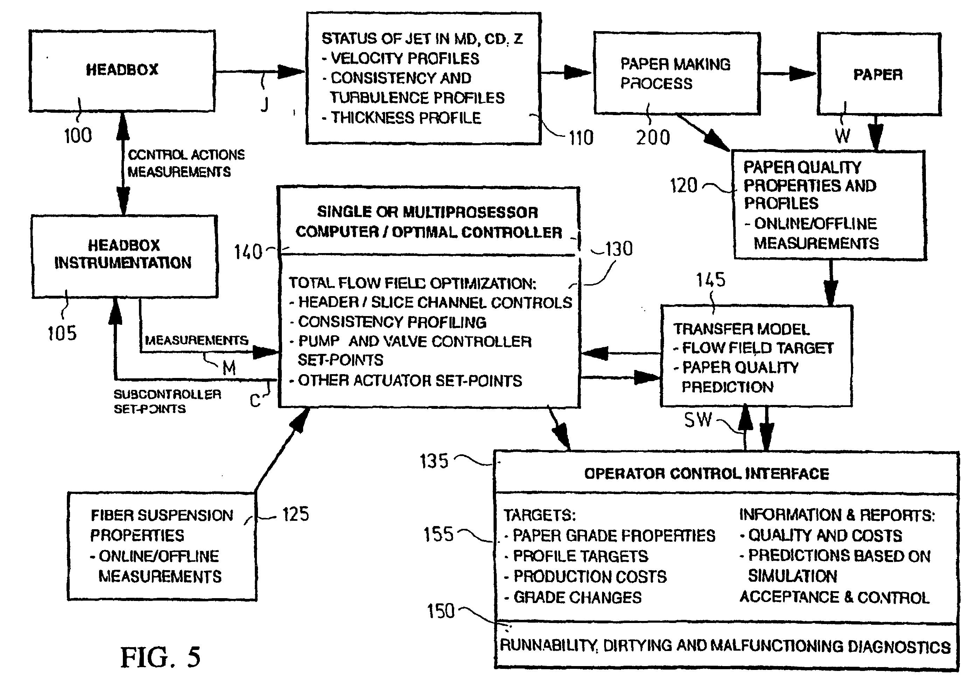

In the illustrations in the present application, the steps and devices of the papermaking process following after the headbox 100 are not illustrated in more detail, because they are known in themselves to a person skilled in the art. To these process steps, reference is made just by the block 200 in the block diagram in Fig. 5.

As is shown in Figs. 1 and 2, in connection with the front wall of the header 12 and/or in connection with the turbulence generator 15, the feed ducts 18 for dilution water, preferably white water, are opened, which ducts are provided with regulation valves 18a, by whose means the distribution of the flow of dilution water is regulated, and in this way the distribution of the consistency of the headbox flow rate in the cross direction y is regulated (Fig. 2). Further, the headbox 100 may be provided with regulation spindles 20 for regulation of the cross-sectional flow area of the header 12. At both sides of the headbox, edge flow feeds 21 of stock have been arranged, which are provided with regulation valves 21a. The slice channel 16 is provided with regulation spindles 19, by whose means the narrowing of the slice channel and/or the profile of the height of the slice opening 17 is/are regulated in the cross direction y. At the upstream side of the slice channel 16, in the flow direction, a series of detectors 22 for measurement of static pressure are fitted. Also, if necessary, the tubes in the turbulence generator 15 can be provided with actuators, such as throttle valves, which regulate the pressure loss profile in the cross direction y. These devices are not shown in the illustrations.

In accordance with the denotations used in Fig. 2, the quantities of measurement and regulation of a single-layer headbox will be given in the following: y = cross direction of the web, x = machine direction of the web, and z = direction of thickness of the web. When a quantity has been denoted as a function of y, i.e. f(y), a cross-direction profile is concerned, which is regulated or computed in accordance with the present invention.

| | |
|---|---|
| $P_{in}$, $C_{in}$, $Q_{in}$ | static pressure, consistency and flow rate of the stock flow into the header 12; |
| $U_{in}(x,z)$ | velocity profile of the flow into the header 12; |
| $A_{in}(y)$ | profile of cross-sectional area of header 12; |
| $C(y)$, $Q_D(y)$ | profiles of consistency and flow rate of the dilution feed 18; |
| $\Delta p_t(y)$, $C_D(y)$ | pressure-loss profile of turbulence generator 15, consistency profile produced by dilution at the outlet end of turbulence generator; |
| $Q_{rec}$, $Q_{e1}$, $Q_{e2}$ | recirculation flow rate and additional-feed flow rates at forward edge and rear edge; |
| $b(x,y)$ | (measured/regulated) shape of slice channel 16 in machine (x) and cross direction (y); |
| $u(y)$, $v(y)$, $w(y)$ | velocity components of slice jet J: u = velocity component in machine direction, v = in cross direction, and w = in z-direction; |
| $c_{jet}(y)$, $t_{jet}(y)$, $E_{jet}(y)$ | consistency, thickness, and turbulence-energy profiles of the slice jet J; |
| $Q_{jet,tot}$ | overall flow rate of slice jet J. |

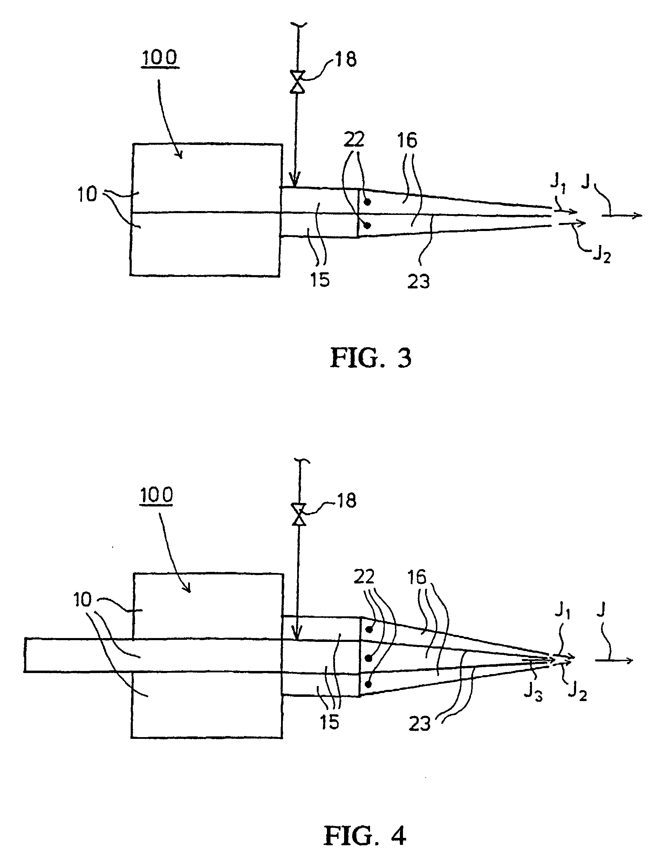

Fig. 3 is a schematic vertical sectional view in the machine direction of a multi-layer headbox construction, while the same reference numerals are used as in Fig. 1. Fig. 3 shows a headbox 100, in which the stock flow passage 10...15,16 has been divided into two layers placed one above the other. In the area of the slice channel 16, there is an intermediate plate 23. In the three-layer headbox as shown in Fig. 4, the stock suspension flow duct 10...15,16 has been divided into three layers placed one above the other, and in the area of the narrowing slice channel 16 there are two intermediate plates 23. Out of the slice channels 16, component jets $J_1$, $J_2$ and $J_3$ are discharged, which are combined into the slice jet J. When the invention is applied in a multi-layer headbox as shown in Figs. 3 and 4, it is necessary to take into account the static and dynamic pressures between the different layers and the forces applied from said pressures to the plate 23 separating the layers. If the plate(s) 23 is/are fixed, said forces are limited by the strength of the construction. If the plate(s) 23 is/are provided with hinges and/or is/are flexible, in the program that is applied in the present invention the factual location of the plate or plates 23 must be computed. This computing can be made as a part of the regulation process based on measurements provided by the instrumentation of the headbox.

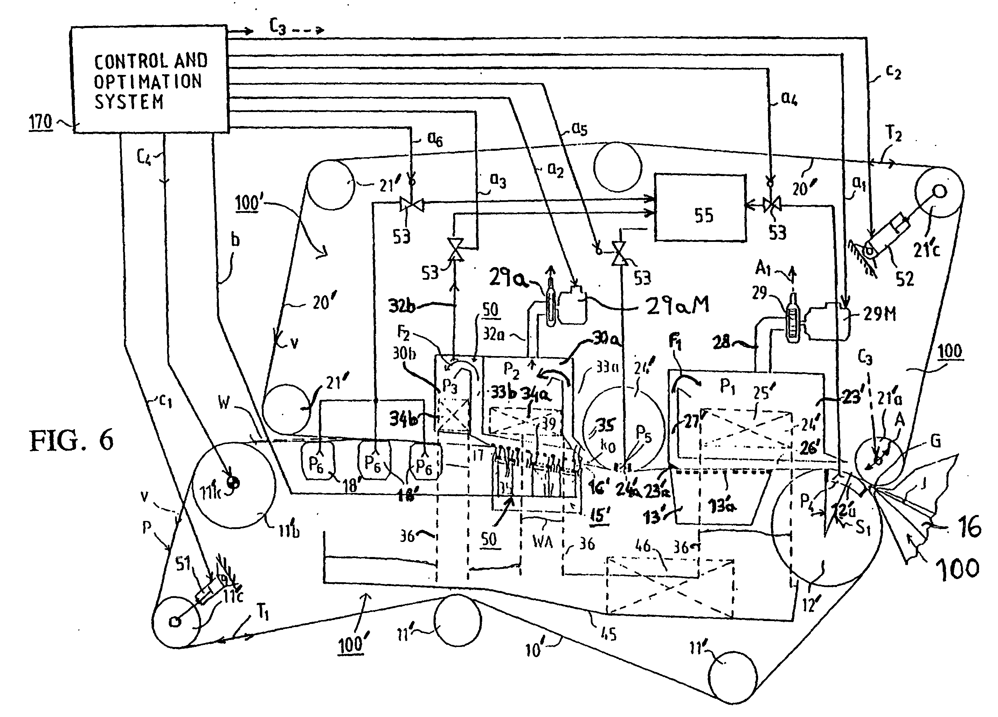

Before the environment (the former) of application of the invention illustrated in Fig. 6 is described in more detail, it should be stated that the former shown in Fig. 6 is just one environment of application of the invention, and attempts have been made to choose such a former for said environment of application in which there is a number as high as possible of actuators to be controlled by means of the regulation method in accordance with the present invention. It should be emphasized that, of course, the invention can be applied in highly different environments, most advantageously in twin-wire formers, but also in fourdrinier wire parts and in former sections of board and pulp machines.

The former 100' of a paper machine shown in Fig. 6 comprises a lower-wire 10' loop, which is guided by the guide rolls 11',11'b,11'c and by the first forming-suction roll 12'. The former 100 comprises an upper-wire 20' loop, which is guided by the guide rolls 21',21'c, by the breast roll 21'a, and by the second forming roll 24'. Through the slice channel 16 of the headbox 100 of the paper machine, a pulp suspension jet J is fed into the forming gap G defined by the forming wires 10' and 20', after which gap G the twin-wire zone starts directly. The first forming-suction roll 12' is placed inside the lower-wire loop 10', and the forming gap G is defined from above by the upper wire 20' running over the breast roll 21'a. The position of the breast roll 21'a is adjustable (arrow A), by means of which adjustability it is possible to act upon the magnitude of the sector $s_1$ of the twin-wire zone placed on the suction zone 12'a of the forming roll 12' and, thereby, upon the web formation.

The twin-wire zone is in contact with the first forming roll 12' on the sector $s_1$, which is followed by the run of the wires 10',20' on which, inside the lower-wire loop 10', there is the stationary forming shoe 13'. The forming shoe 13' has a ribbed deck 13'a with a large curve radius, whose curve centre is at the side of the lower wire 10'. Facing the forming shoe 13', inside the upper-wire loop 20', there is a suction-deflector box 23', at whose rear edge there is a deflector rib 23'a operating against the inner face of the upper wire 20'. The water that is drained from the web W through the upper wire 20' above and ahead of the forming shoe 13' is passed through the space 26' below the box 23' and through the suction-deflector duct 27', in the direction of the arrow $F_1$, into the box 23', from which the water is removed through the duct 25' communicating with the barometric leg 36. A suitable vacuum level $p_1$ is maintained in the box 23' by means of a first blower 29 operated by a first motor 29M. The blower 29 communicates with the box 23' through the duct 28, and air is removed from the box in the direction of the arrow $A_1$.

As is shown in Fig. 6, after the second forming-suction roll 24', in the twin-wire zone, there follows the MB-unit 50. In said MB-unit 50, there is a water drain box 30, which communicates with the barometric leg 36 through the duct 34, the water level in said leg 36 being denoted with WA. Below the water drain box 30, there is a stationary set of support ribs 35. The MB-unit 50 includes two successive water drain chambers 30a and 30b. The first chamber 30a is a suction-deflector chamber, whose suction duct 33a is opened above the first stationary support rib 35. The first chamber 30a communicates with a second blower 29a operated by a second motor 29aM through the duct 32a. The water is drained from the chamber 30a through the duct 34a into the barometric leg 36. Below the first suction chamber 30a there is a loading unit 15', which comprises loading ribs 16', which are loaded by means of pressures passed into the hoses 17' and which are placed facing the gaps between the stationary support ribs 35. Through the gaps between the support ribs 35 the water is drained through the upper wire 20' through the space 39 into the duct 33b and from the duct further in the direction of the arrow $F_2$ into the second suction chamber 30b. The second suction chamber communicates through the duct 32b and through the regulation valve 53 with a source 55 of vacuum. From the chamber 30b the water is drained through the duct 34b communicating with the barometric leg 36. The vacuum level $p_2$ and $p_3$ in each chamber 30a and 30b can be regulated independently from one another by means of valves 53. Through the suction-deflector duct 33a of the first chamber 30a, primarily the water is drained that is separated from the web W directly after the second suction roll 24'.

After the set of ribs 35/16' of the MB-unit 50, inside the lower-wire loop 10', there follow three successive suction flatboxes 18', the web W being separated from the upper wire 20 in the area of the middle one of said boxes and being guided to follow the lower wire 10, from which the web is separated at the pick-up point P and passed on the pick-up fabric to the press section (not shown).

In Fig. 6, the system of regulation and optimization of the former 100' in accordance with the present invention is illustrated schematically as the block 170, which system will be described in more detail later. From this system 170, the regulation signals $a_1,a_2,a_3,a_4,a_5,a_6,b,c_1,c_2,c_3$ and $c_4$ which control the operation of the former 100 are obtained. By means of the regulation signals $a_1...a_6$ the vacuum levels $p_1...p_6$ of the forming members 23,30a,30b,12,24,18 are controlled. The regulation signal $a_1$ controls the speed of rotation of the first motor 29M of the first blower 29, and thus, by its means, it is possible to regulate the vacuum $p_1$ in the box 23'. By means of the regulation signal $a_2$, the speed of rotation of the second motor 29aM of the second blower 29a is controlled, and thus, by its means, it is possible to regulate the vacuum $p_2$ in the box 30a. By means of the regulation signal $a_3$, the regulation valve 53 is controlled, by whose means it is possible to regulate the vacuum $p_3$ in the box 30b communicating with the suction pump 55. By means of the regulation signal $a_4$, the regulation valve 53 is controlled, by whose means it is possible to act upon the vacuum level in the suction zone 12'a of the forming roll 12'. Similarly, by means of the regulation signal $a_5$, the vacuum level $p_5$ in the suction zone 24'a of the forming roll 24' is affected. By means of the regulation signal $a_6$, the vacuum level $p_6$ in the suction flatboxes 18' is affected by means of the regulation valve 53. By means of the regulation signal b, the pressures of pressure media are regulated with which the loading ribs 16' in the unit 15' of the MB-unit 50, placed inside the forming wire 10', are loaded against the stationary ribs 35 placed above. By means of the regulation signals $c_1$ and $c_2$, it is possible to act upon the wire 10',20' tensions $T_1$ and $T_2$. By means of the regulation signal $c_1$, the pressures passed to the actuators, such as first hydraulic cylinders 51, of the tensioning roll 11'c are regulated, and in this way the tension $T_1$ of the lower wire 10' is affected. By means of the regulation signal $c_2$, the actuators, such as the pressures of second hydraulic cylinders 52, of the tensioning roll 21'c of the upper wire 20' are affected, and in this way the tension $T_2$ of the upper wire 20' is regulated. By means of the regulation signal $c_3$, the position of the breast roll 21' and, thus, the length of the curve sector $s_1$ at the initial end of the twin-wire zone, is affected (arrow A). By means of the regulation signal $c_4$, it is possible to act upon the speed v of the wires 10',20'. This regulation of speed is represented by the connection of the regulation signal $c_4$ with the drive 11'k of the roll 11'b of the lower wire 10'.

Fig. 5 is a schematic illustration of the construction of the system of regulation that carries out the method of the present invention as a block diagram. Fig. 5 shows the headbox 100, which was described above and which forms the fiber structure of the paper web W. The properties of the fiber structure are obtained by solving the flow model. The entire papermaking process after the headbox 100, which process is in itself known, is represented by the block 200. The block 200 represents the press section and the dryer section of the paper machine and also possible finishing devices. The transfer function of this process part 200, i.e. the transfer model mentioned above, is known, and it is utilized in the invention in the way that was described above and that will be described later. The properties of the finished paper W, such as quality properties and profiles, are measured before the reel-up by means of on-line or off-line measurements in themselves known, which is illustrated by the block 120. Said block 120 communicates with the block 145, which illustrates the above transfer model of the headbox 100. The properties of the slice jet J are measured by means of on-line or off-line measurements or computed by means of the flow model of the headbox.

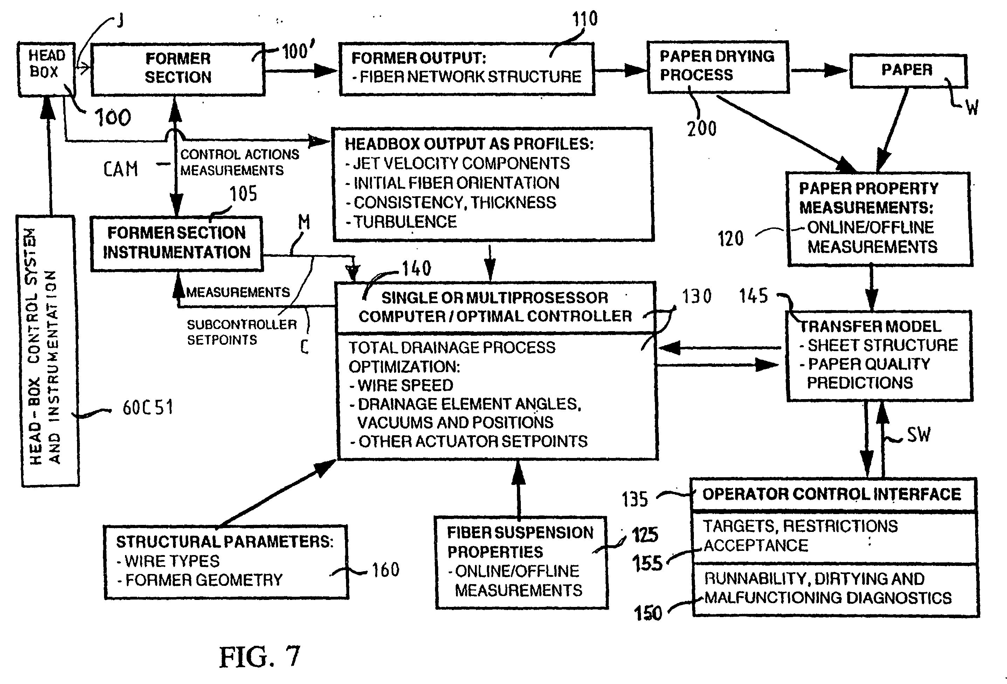

According to Fig. 5 and 7, the core of the system of regulation is the optimal controller 130, to which the target values or set values SW are given in respect of the properties of the paper W and in respect of the production costs through the operator control interface 135. The headbox 100 and the former 100' are connected with its instrumentation, which is illustrated schematically by the block 105, from which the necessary measurement results M are obtained, which are passed to the optimal controller 130. From the optimal controller 130, the set values and the regulation quantities C are received for the instrumentation 105 of the headbox 100 and the former 100'.

The optimal controller 130 includes a computer 140 of high computing capacity, in which the software has been stored that controls the various steps of the method and carries out the necessary computing. The same computer 140 may also operate as a computer that controls the entire papermaking process. The system of regulation includes devices 150 that effect the alarms concerning contamination of the headbox 100 and the condition of the wires and failure operations of the regulation system, said devices being connected with the rest of the system of regulation through the operator control interface 135.

The optimal controller 130 has knowledge of the geometry of the headbox 100 and the former 100', receives information, on the state of the headbox 100 and the former 100' by means of measurements and mechanical controls, and on their basis computes the overall flow state of the headbox 100 and the former 100' at each particular time. Starting from the basic equations of the flow, from the quality properties and profiles of the paper W, which can be measured either in an on-line process or from off-line paper, from the flow properties of the stock (consistency, composition, fiber length, etc.), the optimal controller 130 computes the set values for the instrumentation 105 and for the auxiliary devices of the headbox 100, such as pumps, in relation to the quality and production-cost target values set by the operator through the operator control interface 135 so as to accomplish a coordinated optimal flow state. Of the production costs concerning the headbox 100, it is possible to analyze, for example, the extent of the recirculation flow rate $Q_{rec}$ and the necessary overall flow, which determine the necessary quantity of water and the pumping costs. Of the quality and grade quantities should be mentioned, for example, the basis weight and fiber-orientation and formation profiles, *all* of which are directly and simultaneously dependent on the velocity field and the consistency and turbulence state of the slice jet J, which are obtained as a result of computing.

Of the production costs concerning the former 100', it is possible to mention, for example, the operating output. Of the quality quantities should be mentioned, for example, the formation, retention, and orientation level, all of which depend on the flow state of the former, which is obtained as a result of computing.

According to Fig. 5 and 7, as to its main principles, the system of regulation that makes use of the method of the present invention is a closed, feedback-connected system of regulation, whose "actual values" are the various quality properties and y-direction cross profiles of the paper web W coming from the papermaking process 200, and whose set values SW are formed in the unit 155, in which the information necessary for the operator is formed and displayed and reports are given on the paper W quality and on the production costs as well as the predictions based on simulation. On their basis, the instrumentation 105 of the headbox 100 and the former are controlled by means of the optimal controller 130. The outer and wider regulation loop in the system of regulation in accordance with the present invention is a loop formed by the instrumentation 105 of the headbox 100 and the former 100', by the measurements M, by the optimal controller 130, by the transfer model 145, and by the set values SW, and the inner, narrower cycle of regulation is C → 105 → M → 130.

On the other hand, in Fig. 7, the connection CAM between the blocks 100' and 105 represents the regulation signals $a_1...a_6$, b, $c_1...c_4$ illustrated in Fig. 6 and possible measurement signals, which are not needed necessarily and which are not illustrated in Fig. 6.

Also, in Fig. 7, as the block 60CSI, a system of regulation and instrumentation of the headbox is illustrated, which system controls the headbox 100. The system 60CSI can be an overall system of regulation and optimization similar to that described above and afterwards.

The operation of the system of regulation sketched in Fig. 5 and 7 is based on the idea that the flows in the headbox 100 and the former 100' are illustrated as precisely as possible by means of a physical flow model, which is solved numerically by means of the computer 140.

As an example of a physical flow model should be mentioned the Navier-Stokes equations (1) and (2):

$$\rho\frac{\partial\vec{u}}{\partial t} - \nabla \cdot [\mu(\nabla\vec{u} + \nabla\vec{u}^T)] + \rho(\vec{u}\cdot\nabla)\vec{u} + \nabla p = \rho\vec{f} \qquad (1)$$

$$\nabla \cdot \vec{u} = 0 \qquad (2)$$

wherein $\vec{u}$ is the flow velocity, p is the static pressure, $\vec{f}$ is the volumetric force (e.g. gravitation), $\mu$ is the effective viscosity of flowing material, and $\rho$ is the density of said material.

For the fiber suspension flow in the headbox 100 and in the former 100', besides for the fluid flow, equations are also needed for the dry solids and for the turbulence. It is a substantial feature of the physical flow model that it is derived starting from basic equations of physics and not, for example, by fitting values that have been measured from the processes statistically into simple interdependences or response models.

In the final part of the papermaking process 200, the properties of the paper W are measured on-line (block 120 in Fig. 5 and 7). Further, it is possible to make use of off-line laboratory measurements. The most important properties of paper W are, for example, the basis weight and fiber orientation profiles in the direction of width of the machine, i.e. in the cross direction y.

When the properties $R^p$ of paper W (p = paper) are known by means of measurements (block 120), and when the properties of the jet $R^j$ (j = jet) are known by means of the flow model, based on these properties it is possible to form a transfer mapping T, i.e. the above transfer model for the effect of the papermaking process 200 on said property when moving from the jet J of Fig. 2 to finished paper W:

$$T : R^j \rightarrow R^p \qquad (3)$$

The property R mentioned above is, for example, basis weight profile, i.e. $R^j$ is the numerically simulated basis weight profile in the jet J, and $R^p$ is the measured basis weight profile in the finished paper W.

The inverse mapping of this mapping is:

$$T^{-1} : R^p \rightarrow R^j \qquad (4)$$

When the properties $R^p$ of paper W (p = paper) are known by means of measurements (block 120), and when the properties of the web after the former $R^f$ (f = former) are known by means of the flow model, based on these properties it is possible to form a transfer mapping T, i.e. the above transfer model for the effect of the papermaking process 200 on said property when moving from the former of Fig. 2 to finished paper W:

$$T : R^f \rightarrow R^p \qquad (3a)$$

The property R mentioned above is, for example, moisture profile, i.e. $R^f$ is the numerically simulated volumetric proportion of water after the former, and $R^p$ is the measured moisture profile in the finished paper W.

The inverse mapping of this mapping is:

$$T^{-1} : R^p \rightarrow R^f \tag{4a}$$

For the optimal controller 130 it must be defined what is aimed at in the optimizing. Some of the most important aims of the stage of optimizing in the method of the present invention are the quality requirements of the paper W. When the inverse mapping of the transfer function T is known, by its means it is possible to set the targets for the slice jet of the headbox 100 and for the former 100'. For example, if an orientation profile $\theta^p(y)$ is desired for the paper, it is reported to the system of regulation that in the jet J the orientation profile must be $T^{-1}(\theta^p(y)) = \theta^j(y)$ and that after the former the orientation profile must be $T^{-1}(\theta^p(y)) = \theta^f(y)$. In a corresponding way, a target basis weight profile of paper W is transferred to be the target basis weight profile in the slice jet J and of the former 100'. Moreover, it can be set as a target to reach these quality requirements with minimal costs of operation of the paper machine.

The target of the stage of optimizing of the headbox 100 is written as a cost function. The cost function determines in a mathematical form how near or far the desired target is. Generally, the cost function is of the form:

$$F = \sum_{k=1}^{n} w_k \parallel R^j_k - R^j_{k*} \parallel + \sum_{l=1}^{m} e_l \parallel E_l - E_{l*} \parallel \tag{5}$$

wherein $R^j_k$ means the property k = 1,...,n simulated by means of the flow model in the jet, and $R^j_{k*}$ means the target property obtained by means of an inverse mapping from the properties of the paper in the slice jet J, i.e. $R^j_{k*} = T^{-1}(R^p)$.

The target of the stage of optimizing of the former 100' is written as a cost function. The cost function determines in a mathematical form how near or far the desired target is. Generally, the cost function is of the form:

$$F = \sum_{k=1}^{n} w_k \parallel R^f_k - R^f_{k*} \parallel + \sum_{l=1}^{m} e_l \parallel E_l - E_{l*} \parallel \tag{5a}$$

wherein $R^f_k$ means the property k = 1,...,n simulated by means of the flow model after the former, and $R^f_{k*}$ means the target property obtained by means of an inverse mapping from the properties of the paper in the former, i.e. $R^f_{k*} = T^{-1}(R^p)$.

The weight function $w_k$ determines the relative weights of the different properties in the cost function. In the second part of the cost function it has been produced as a pattern how close the other economical, energy-consumption or runnability targets $E_l$ are to the preset targets $E_{l*}$ as weighted with the target-specific weight coefficient $e_l$ (l = 1,..., m). Here the norm $\parallel X-X_* \parallel$ means the distance of the actual value X from the target $X_*$, which can be defined over a certain geometry, for example as the $L_2$-norm, i.e integral of the second power of the difference:

$$\parallel X-X_* \parallel = \frac{1}{L} \int_0^L (X-X_*)^2 dy \tag{6}$$

The value of the cost function F depends on the solutions $S_k$ of the flow model of the headbox 100 and the former 100', which again depends on the set values of the regulation quantities $\vec{\alpha} = [\alpha_1...\alpha_n]$ of the headbox 100 and of the former 100'. Thus, the cost function for the headbox 100 is obtained in the form:

$$F(S(\vec{\alpha})) = \sum_{k=1}^{n} w_k \parallel R^j_k(S(\vec{\alpha})) - T^{-1}_k(R^p) \parallel + \sum_{l=1}^{m} e_l \parallel E_l - E_{l*} \parallel \qquad (7)$$

The cost function for the former 100' is in the form:

$$F(S(\vec{\alpha})) = \sum_{k=1}^{n} w_k \parallel R^f_k(S(\vec{\alpha})) - T^{-1}_k(R^p) \parallel + \sum_{l=1}^{m} e_l \parallel E_l - E_{l*} \parallel \qquad (7a)$$

The first part of the cost function to be optimized for the headbox 100 can also be formed directly for the quality requirements of paper W by using the pattern T, because

$$\left\| R^j(S(\vec{\alpha})) - T^{-1}(R^p) \right\| = \left\| T(R^j(S(\vec{\alpha}))) - R^p \right\| \qquad (8)$$

The first part of the cost function to be optimized for the former 100' can also be formed directly for the quality requirements of paper W by using the pattern T, because

$$\left\| R^f(S(\vec{\alpha})) - T^{-1}(R^p) \right\| = \left\| T(R^f(S(\vec{\alpha}))) - R^p \right\| \qquad (8a)$$

and when the properties $R^p$ of the paper W can be represented sufficiently unequivocally by means of the properties $R^j$ of the jet J or the properties $R^f$ of the web. In such a case, the weight coefficients of the cost function must be considered in relation to the properties $R^p$ of the paper W and not in relation to the properties $R^j$ of the jet or not in the relation to the properties $R^f$ of the web after the former 100', i.e. either

(1) one moves from the properties of the paper W to the properties of the slice jet J or of the former 100' by means of the inverse mapping $T^{-1}$ or

(2) from the properties of the slice jet J or of the former 100' to the properties of the paper W by means of the mapping T.

The purpose of the optimizing stage applied in the present invention is to minimize the cost function $(F(S(\vec{\alpha})))$ so that the solution $S(\vec{\alpha})$ carries into effect the flow model of the headbox 10/former 100' and that the values of the regulation variables $C = \vec{\alpha} = [\alpha_1...\alpha_n]$ are included in the admissible regulation values.

On the other hand, it is desirable to maximize some quantity, for example $E_g$, the norm $\parallel g(E_g) \parallel$ in respect of said property can always be written so that the value of the cost function reaches the minimum while the quantity $g(E_g)$ is maximized or while the quantity $-g(E_g)$ is minimized.

For the practical conditions, the operator may look for the best combinations of the weight coefficients $w_k$ and $e_l$ of the cost function (formula (5) and (5a)) by using the flow model of the optimal regulator of the headbox and the transfer model 145 to simulate the effects of the combinations of different regulations and weight coefficients on the paper W that is being manufactured.

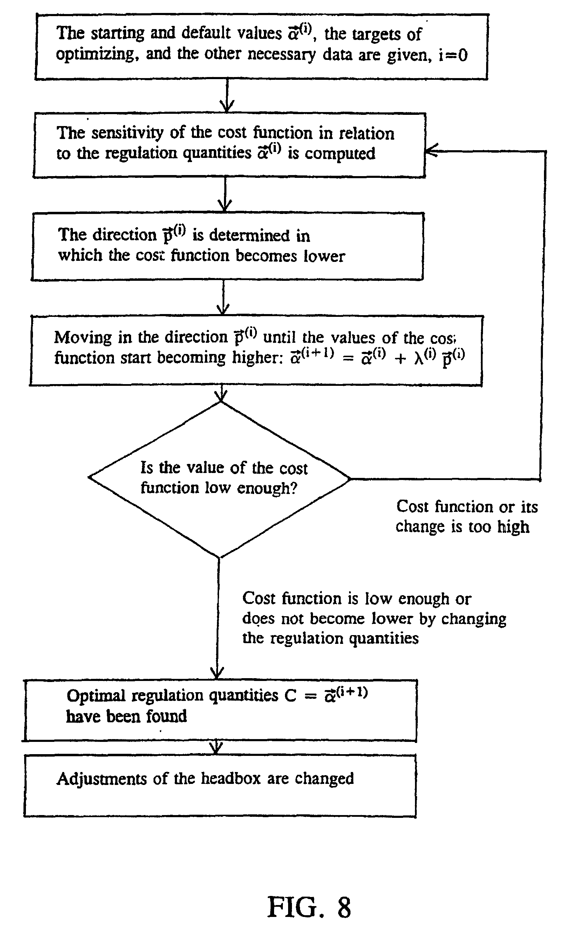

The stage of optimal regulation applied in the invention operates, for example, in accordance with the following algorithm (a corresponding flow diagram is given in the accompanying Fig. 8):

0. The necessary flow-rate, stock-grade and geometry data of the headbox 100/former 100' are read. The optimizing is started from the default values $\vec{\alpha}^{(i)}, i=0$, and the value $F^{(i)}$ of the cost function is computed by solving the flow model of the headbox 100/former 100'.

1. The gradient $\nabla F^{(i)}$ of the cost function with the regulation values $\vec{\alpha}^{(i)}$ concerned is computed. The computing of the gradient (= sensitivity of the cost function in relation to the regulation) requires solution of the flow model of the headbox 100/former 100'.

2. The direction $\vec{p}^{(i)}$ is determined which states in what direction the regulation quantities must be changed in order to lower the value of the cost function. At the simplest, the direction can be the direction $\vec{p}^{(i)} = -\nabla F^{(i)}$ obtained by means of the gradient. This is what is called the gradient method, i.e. the steepest descent direction method. Other gradient-based methods are, for example, the conjugate gradient method and the quasi-Newton's methods.

3. The new values of the regulation values $\vec{\alpha}^{(i+1)}$ (Fig. 8) are obtained by varying them in said direction optimally

$$\vec{\alpha}^{(i+1)} = \vec{\alpha}^{(i)} + \lambda^{(i)} \vec{p}^{(i)}, \tag{9}$$

i.e. the step length $\lambda^{(i)}$ is determined so that the cost function receives a lower value than with the preceding iteration, $F^{(i+1)} < F^{(i)}$, and the regulation quantities $\vec{\alpha}^{(i+1)}$ are permitted. In the search for a good step length, computing of the values of the cost function and, thus, solution of the flow model are required.

4. If the value of the cost function is not yet sufficiently low, an index for iteration step is increased, i = i+1, and optimizing is continued from point 1. In the contrary case, optimizing is discontinued, and the values of optimal regulation quantities $C = \vec{\alpha}^{(i+1)}$ are transmitted to the regulation devices 105 of the headbox 100/former 100'.

In the following, the patent claims will be given, and the various details of the invention may show variation within the scope of the inventive idea defined in said claims and differ even considerably from the exemplifying embodiments described above for the sake of example only.

## Claims

**1.** A method for continuous overall regulation of a single-layer or multi-layer head box and/or a former of a paper, board or pulp-draining machine, comprising the steps of:

(a) forming a physical fluid flow model of the pulp suspension flow to be regulated in the head box (100)/former (100');
(b) solving the flow model to obtain a simulated flow state based on data on a geometry of the head box (100)/former (100') and initial and boundary conditions related to the head box (100)/former (100');
(c) obtaining a target flow state based on quality requirements of the paper produced from the pulp suspension flow and costs of operation and runnability of the paper machine;
(d) determining a difference between the simulated flow state and the target flow state, the difference constituting a cost function, which is composed at least of target profiles of the finished paper (W), in particular of the basis weight and fibre orientation profiles or of values computed from these quantities;
(e) optimising the cost function and then determining optimal regulation values and set values (C) for the instrumentation devices and actuators (105) of the head box (100)/former (100'), which affect the pulp suspension flow in the head box (100) and/or the drainage and flow state of the pulp suspension flow in the former (100'), in view of the cost function; and
(f) providing the optimal regulation values and set values (C) to the regulation devices of the head box (100)/former (100') such that the regulation devices of the head box (100)/former (100') operate at the optimal regulation values to thereby realise the optimisation of the cost function.

**2.** A method as claimed in claim 1, **characterized in that** the flow model of the headbox and/or the former is formed on the basis of the basic laws of fluid dynamics, i.e of the conservation and material laws, or on the basis of simplified equations derived from said laws, and that equations are solved numerically by means of a computer, and that on-line and/or laboratory measurements as well as information provided by the operator of the paper machine are used as the initial and boundary values of the flow model.

**3.** A method as claimed in claim 1 or 2, **characterized in that**, by means of a physical model, a sufficiently high number of flow states are computed, and by their means a simpler statistical model or a so-called neuro-network is adapted or instructed to illustrate the flow state of the headbox and/or the former and/or the dependences of the cost function from the regulation quantities, and this model is used for optimizing.

4. A method as claimed in any of the claims 1 to 3, **characterized in that** said flow model is solved by means of a computer (140) of high computing capacity comprising one or several processors by using numerical methods of solution, such as finite-element, finite-difference and finite-volume methods in themselves known or equivalent.

5. A method as claimed in any of the claims 1 to 4, **characterized in that** the optimizing of said cost function and the optimal regulation are carried out in accordance with the following algorithm:

   (a) the necessary flow-rate, stock-grade and geometry data of the headbox (100)/former (100') are read, and the optimizing is started from the default regulation values $\vec{\alpha}^{(i)}$, i=0, and the value $F^{(i)}$ of the cost function is computed by solving the flow model of the headbox (100)/former (100'),

   (b) the gradient $\nabla F^{(i)}$ of the cost function with the regulation values $\vec{\alpha}^{(i)}$ concerned is computed,

   (c) the direction $\vec{p}^{(i)}$ is determined by means of the gradient $\nabla F^{(i)}$, which direction states in what direction the regulation quantities must be changed in order to lower the value of the cost function, for example, $\vec{p}^{(i)} = -\nabla F^{(i)}$, i.e. the gradient method, or any other gradient-based method in itself known, in which the sensitivity of the cost function F in relation to the regulation quantity $\alpha_k$ is computed by means of the difference quotient

$$\frac{\partial}{\partial_k} F = \frac{F(\alpha_k + \varepsilon) - F(\alpha_k)}{\varepsilon}$$

   or by solving the adjoint state equation corresponding to the flow model of the headbox (100)/former (100'),

   (d) the new values of the regulation quantities $(\vec{\alpha}^{(i+1)})$ are determined by varying them in the direction determined in the preceding step (c) optimally

$$\vec{\alpha}^{(i+1)} = \vec{\alpha}^{(i)} + \lambda^{(i)} \vec{p}^{(i)},$$

   in which connection the step length $\lambda^{(i)}$ is determined so that the cost function receives a lower value than with the preceding iteration, $F^{(i+1)} < F^{(i)}$, and the regulation quantities ($\vec{\alpha}^{(i+1)}$) are admissible, and

   (e) if the value of the cost function obtained in the preceding steps is not yet sufficiently low, an index for iteration step is increased, i = i+1, and optimizing is continued from the above stage (b), and in the contrary case, performing of the algorithm is discontinued, and the values of regulation quantities (C) are set equal to the optimized values $\vec{\alpha}^{(i+1)}$ and they are transmitted to the regulation devices (105) of the headbox (100)/former (100').

6. A method as claimed in any of the claims 1 to 4, wherein the optimum of the cost function is sought by means of some other known algorithm, which is not based on computing of the gradient of the cost function.

7. A method as claimed in claim 1, **characterized in that**, besides said target profiles, said cost function also comprises components related to the runnability and/or energy consumption of the paper machine.

8. A method as claimed in any of the claims 1 to 7, **characterized in that**, in the method, a certain quality level is chosen for finished paper (W), and in the headbox (100) the lowest possible overall flow rate and energy consumption are sought, preferably by minimizing the recirculation flow rate ($Q_{rec}$), with which said quality level is reached and/or in the former (100') the lowest possible energy consumption is sought, preferably by minimizing the consumption of jet waters and the wear of wires and water drain elements with which said quality level is reached.

9. A method as claimed in any of the claims 1 to 8, **characterized in that** different weights are set for different parts of the cost function, preferably so that the quality of the paper is set as the most important one, and that, if the runnability can be improved and/or energy be saved without deteriorating the quality, these are carried into effect by means of the method of the invention.

**10.** A method as claimed in any of the claims 1 to 9, **characterized in that** the cost function to be optimized is made to include quality quantities, which are in the headbox (100) expressed by means of the velocity profile and the turbulence of the slice jet (J), i.e. the slice jet (J) discharged out of the slice opening (17) of the headbox is optimized, and/or which are in the former (100'), which are expressed by means of the properties of the web after the former.

**11.** A method as claimed in any of the claims 1 to 10, **characterized in that**, when the method is being carried out, the computing taking placed by means of the computer (140) is made quicker by performing the computing in parallel by means of a computer of several processors or by means of computers, preferably so that the sensitivities of the changes in the cost function in relation to different regulation quantities are computed each of them by means of a processor of its own.

**12.** A method as claimed in claim 11, **characterized in that** the sensitivities of the cost function in relation to different regulation quantities are determined by means of a sensitivity analysis, which is carried out in an environment of linearized solution so that the flow model is solved by means of a perturbation theory or equivalent by determining the gradient of the cost function and by for the optimizing, in the other respects, using a real non-linear model, in which case the optimizing proper is based on a real flow model, and any faults arising from the perturbation theory or equivalent have no substantial effect on the final result of the optimizing.

**13.** A method as claimed in any of the claims 1 to 12, **characterized in that** the flow model of the headbox (100)/former (100') is/are composed of a number of sub-models, which are solved at the same time, and in between data are updated between the processors that compute different sub-models, depending on the solutions of the sub-models.

**14.** A method as claimed in any of the claims 1 to 13, **characterized in that** the computing necessary in the method is enhanced by dividing the optimizing into parts preferably so that the regulation quantities that have the greatest effect on the quality of the finished paper (W) are optimized more frequently while reacting to the changes rapidly, whereas the other parameters are optimized less frequently, and that for optimizing of the regulation quantities for which the whole flow model is not needed a suitable sub-model is used.

**15.** A method as claimed in any of the claims 1 to 14, **characterized in that** the measurement and regulation quantities of the headbox (100) to be regulated are chosen among the following group:

— static pressure ($P_{in}$), consistency ($C_{in}$) and flow rate ($Q_{in}$) of the stock flow into the header (12);
— velocity profile ($U_{in}(x,z)$) of the flow into the header (12);
— profile of cross-sectional area ($A_{in}(y)$) of header (12);
— profiles of consistency and flow rate ($C(y),Q_D(y)$) of dilution feed (18);
— pressure-loss profile ($\Delta p_t(y)$) of turbulence generator (15), consistency profile ($C_D(y)$) produced by dilution at the outlet end of turbulence generator;
— recirculation flow rate ($Q_{rec}$) and edge feed flow rates ($Q_{e1},Q_{e2}$) at forward edge and rear edge;
— measured/regulated shape ($b(x,y)$) of slice channel (16) in machine (x) and cross direction (y);
— velocity components ($u(y)$, $v(y)$, $w(y)$) of slice jet (J);
— consistency ($c_{jet}(y)$), thickness ($t_{jet}(y)$) and turbulence-energy profiles ($E_{jet}(y)$) of the slice jet (J);
— overall flow rate ($Q_{jet,tot}$) of the slice jet (J).

**16.** A method as claimed in any of the claims 1 to 15, **characterized in that**, in the method, all, or the most important ones, of the regulation parameters of the former section are regulated as overall regulation, such as the vacuum levels of the forming rolls, MB-boxes, forming shoes and/or suction flatboxes; positions of forming rolls and/or of forming ribs and/or loading forces and/or positions of the water drain elements; tensions of the forming wires; retention and/or profiling of retention and/or any other possible parameters that affect the web formation and the draining of water taking place out of the web in the former section.

**17.** A method as claimed in any of the claims 1 to 17, **characterized in that** the method is applied in a paper machine in connection with change of paper grade, so that, by means of the model to be applied in the method, new optimal regulation values are predicted for the paper grade to be run next, the purpose being to reduce the time taken by the change of grade and to increase the operating time ratio of the paper machine.

**Patentansprüche**

1. Verfahren zum kontinuierlichen Gesamtregulieren eines Einzellagenstoffauflaufkastens oder Mehrlagenstoffauflaufkastens und / oder eines Formers einer Papiermaschine, Pappmaschine oder Halbstoffablaufmaschine mit den folgenden Schritten:

(a) Bilden eines physikalischen Fluidströmungsmodells der Halbstoffsuspensionsströmung, die bei dem Stoffauflaufkasten (100) / Former (100') zu regulieren ist;

(b) Auflösen des Strömungsmodells, um einen simulierten Strömungszustand zu erhalten, auf der Grundlage der Daten der Geometrie des Stoffauflaufkastens (100) / Formers (100') und sich auf den Stoffauflaufkasten (100) / Former (100') beziehenden Anfangs- und Grenzbedingungen;

(c) Erhalten eines Zielströmungszustandes auf der Grundlage von Qualitätserfordernissen des von der Halbstoffsuspensionsströmung hergestellten Papiers und Kosten des Betriebs und des Laufverhaltens der Papiermaschine;

(d) Bestimmen einer Differenz zwischen dem simulierten Strömungszustand und dem Zielströmungszustand, wobei die Differenz eine Kostenfunktion bildet, die zumindest aus Zielprofilen des fertigen Papiers (W) insbesondere des Basisgewichtsprofils und Faserausrichtungsprofils oder aus Werten besteht, die aus diesen Größen berechnet worden sind;

(e) Optimieren der Kostenfunktion und dann Bestimmen von optimalen Regulierungswerten und Einstellwerten (C) für die Instrumentationsvorrichtungen und Betätigungsglieder (105) des Stoffauflaufkastens (100) / Formers (100'), die die Halbstoffsuspensionsströmung in dem Stoffauflaufkasten (100) und / oder den Ablauf- und Strömungszustand der Halbstoffsuspensionsströmung in dem Former (100') beeinflussen, im Hinblick auf die Kostenfunktion; und

(f) Vorsehen der optimalen Regulierungswerte und Einstellwerte (C) für die Regulierungsvorrichtungen des Stoffauflaufkastens (100) / Formers (100') derart, dass die Regulierungsvorrichtungen des Stoffauflaufkastens (100) / Formers (100') bei den optimalen Regulierungswerten arbeiten, um dadurch die Optimierung der Kostenfunktion zu verwirklichen.

2. Verfahren gemäß Anspruch 1,
   **dadurch gekennzeichnet, dass**
   das Strömungsmodell des Stoffauflaufkastens und / oder des Formers auf der Grundlage der Grundgesetze der Fluiddynamik, d. h. der Erhaltungs- und Stoffgesetze, oder auf der Basis von vereinfachten Gleichungen, die aus diesen Gesetzen hergeleitet sind, gebildet wird, und
   diese Gleichungen numerisch mittels eines Computers gelöst werden, und
   in der Produktionslinie und / oder im Labor vorgenommene Messungen und auch von dem Bediener der Papiermaschine vorgesehene Informationen als die Anfangs- und Grenzwerte des Strömungsmodells verwendet werden.

3. Verfahren gemäß Anspruch 1 oder 2,
   **dadurch gekennzeichnet, dass**
   durch ein physikalisches Modell eine ausreichend hohe Anzahl an Strömungszuständen berechnet wird, und durch diese ein einfacheres statistisches Modell oder ein sogenanntes Neuro-Netzwerk aufgegriffen oder instruiert wird, um den Strömungszustand des Stoffauflaufkastens und / oder des Formers und / oder die Abhängigkeiten der Kostenfunktion von den Regulierungsgrößen darzustellen, und wobei dieses Modell für das Optimieren verwendet wird.

4. Verfahren gemäß einem der Ansprüche 1 bis 3,
   **dadurch gekennzeichnet, dass**
   das Strömungsmodell mittels eines Computers (140) mit einer hohen Berechnungsleistung, der einen oder mehrere Prozessoren aufweist, unter Verwendung von numerischen Lösungsverfahren wie beispielsweise das Finite-Elemente-Verfahren, das Finite-Differenz-Verfahren und das Finite-Volumen-Verfahren, die an sich bekannt sind, oder dergleichen gelöst wird.

5. Verfahren gemäß einem der Ansprüche 1 bis 4,
   **dadurch gekennzeichnet, dass**
   das Optimieren der Kostenfunktion und die optimale Regulierung gemäß dem folgenden Algorithmus ausgeführt werden:

(a) die erforderliche Strömungsrate, Ganzstoffsorte und Geometriedaten des Stoffauflaufkastens (100) / Formers (100') werden gelesen und das Optimieren wird von den Fehlregulierungswerten $\vec{\alpha}^{(i)}$, i=0 gestartet, und der Wert $F^{(i)}$ der Kostenfunktion wird berechnet, indem das Strömungsmodell des Stoffauflaufkastens (100) / Formers (100') gelöst wird.

(b) der Gradient $\nabla F^{(i)}$ der Kostenfunktion mit den betreffenden Regulierungswerten $\vec{\alpha}^{(i)}$ wird berechnet,

(c) die Richtung $\vec{p}^{(i)}$ wird mittels des Gradienten $\nabla F^{(i)}$ bestimmt, wobei diese Richtung angibt, in welcher Richtung die Regulierungsgrößen geändert werden müssen, um den Wert der Kostenfunktion zu senken, beispielsweise $\vec{p}^{(i)}=-\nabla F^{(i)}$, d. h. das Gradientenverfahren oder irgendein anderes an sich bekanntes auf einen Gradienten gegründetes Verfahren, bei dem die Empfindlichkeit der Kostenfunktion F in Bezug auf die Regulierungsgröße $\alpha_k$ berechnet wird mittels des Differentialquotienten

$$\frac{\partial}{\partial_k} F = \frac{F(\alpha_k + \varepsilon) - F(\alpha_k)}{\varepsilon}$$

oder durch ein Lösen der Gleichung des adjungierten Zustands entsprechend dem Strömungsmodell des Stoffauflaufkastens (100) / Formers (100'),

(d) die neuen Werte der Regulierungsgrößen ($\vec{\alpha}^{(i+1)}$) werden bestimmt, indem sie in der Richtung, die bei dem vorherigen Schritt (c) bestimmt worden ist, optimal variiert werden

$$\vec{\alpha}^{(i+1)} = \vec{\alpha}^{(i)} + \lambda^{(i)} \vec{p}^{(i)},$$

wobei in diesem Zusammenhang die Schrittlänge $\lambda^{(i)}$ so bestimmt wird, dass die Kostenfunktion einen niedrigeren Wert als bei der vorherigen Iteration empfängt, $F^{(i+1)}<F^{(i)}$, und die Regulierungsgrößen ($\vec{\alpha}^{(i+1)}$) zulässig sind, und

(e) wenn der Wert der Kostenfunktion, der bei den vorherigen Schritten erhalten wird, noch nicht ausreichend gering ist, wird ein Index für den Iterationsschritt erhöht, $i=i+1$, und ein Optimieren wird von der vorstehend erwähnten Stufe (b) fortgesetzt, und im entgegengesetzten Fall wird ein Ausführen des Algorithmus unterbrochen, und die Werte der Regulierungsgrößen (C) werden gleich den optimierten Werten $\vec{\alpha}^{(i+1)}$ eingestellt und sie werden zu den Regulierungsvorrichtungen (105) des Stoffauflaufkastens (100) / Formers (100') übertragen.

**6.** Verfahren gemäß einem der Ansprüche 1 bis 4, wobei
das Optimum der Kostenfunktion durch einen anderen bekannten Algorithmus gesucht wird, der nicht auf das Berechnen des Gradienten der Kostenfunktion gegründet ist.

**7.** Verfahren gemäß Anspruch 1,
**dadurch gekennzeichnet, dass**
neben den Zielprofilen die Kostenfunktion auch Komponenten aufweist, die sich auf das Laufverhalten und / oder den Energieverbrauch der Papiermaschine beziehen.

**8.** Verfahren gemäß einem der Ansprüche 1 bis 7,
**dadurch gekennzeichnet, dass**
bei dem Verfahren eine bestimmte Qualitätshöhe für das fertige Papier (W) gewählt wird und bei dem Stoffauflaufkasten (100) die niedrigst mögliche Gesamtströmungsrate und der niedrigst mögliche Energieverbrauch gesucht werden, vorzugsweise durch ein Minimieren der Rezirkulationsströmungsrate ($Q_{rec}$) , mit der die Qualitätshöhe erreicht wird, und / oder bei dem Former (100') der niedrigst mögliche Energieverbrauch gesucht wird, vorzugsweise durch ein Minimieren des Verbrauchs an Strahlwasser und des Verschleißes der Siebe und der Wasserablaufelemente, mit denen die Qualitätshöhe erreicht wird.

**9.** Verfahren gemäß einem der Ansprüche 1 bis 8,
**dadurch gekennzeichnet, dass**
verschiedene Gewichtungen für verschiedene Teile der Kostenfunktion vorzugsweise so eingestellt werden, dass die Qualität des Papiers als das Wichtigste eingestellt wird, und dass, wenn die Lauffähigkeit verbessert werden kann und / oder Energie eingespart werden kann, ohne die Qualität zu verschlechtern, diese mittels des Verfahrens der Erfindung verwirklicht werden.

**10.** Verfahren gemäß einem der Ansprüche 1 bis 9,

**dadurch gekennzeichnet, dass**

die zu optimierende Kostenfunktion so gestaltet wird, dass sie Qualitätsgrößen umfasst, die bei dem Stoffauflaufkasten (100) durch das Geschwindigkeitsprofil und die Turbolenz des Auslaufdüsenstrahls (J) ausgedrückt sind, d. h. der Auslaufdüsenstrahl (J), der aus der Auslaufdüsenöffnung (17) des Stoffauflaufkastens abgegeben wird, wird optimiert, und / oder die bei dem Former (100') ausgedrückt sind, die mittels der Eigenschaften der Bahn nach dem Former ausgedrückt werden.

**11.** Verfahren gemäß einem der Ansprüche 1 bis 10,
**dadurch gekennzeichnet, dass**

wenn das Verfahren ausgeführt wird, das mittels des Computers (140) stattfindende Berechnen schneller gestaltet wird, indem das Berechnen parallel durch einen Computer mit verschiedenen Prozessoren oder durch Computer vorzugsweise so ausgeführt wird, dass die Empfindlichkeiten der Änderungen bei der Kostenfunktion in Bezug auf verschiedene Regulierungsgrößen jeweils von einem Prozessor für sich allein berechnet werden.

**12.** Verfahren gemäß Anspruch 11,
**dadurch gekennzeichnet, dass**

die Empfindlichkeiten der Kostenfunktion in Bezug auf verschiedene Regulierungsgrößen mittels einer Empfindlichkeitsanalyse bestimmt werden, die bei einer Umgebung einer linearisierten Lösung so ausgeführt wird, dass das Strömungsmodell mittels einer Störungstheorie oder dergleichen durch Bestimmung des Gradienten der Kostenfunktion und durch, für das Optimieren, in anderer Hinsicht unter Verwendung eines realen, nicht linearen Modells gelöst wird, wobei in diesem Fall das eigentliche Optimieren auf ein reales Strömungsmodell gegründet ist, und jegliche von der Störungstheorie oder dergleichen herrührende Fehler keinen wesentlichen Einfluss auf das Endergebnis der Optimierung haben.

**13.** Verfahren gemäß einem der Ansprüche 1 bis 12,
**dadurch gekennzeichnet, dass**

das Strömungsmodell des Stoffauflaufkastens (100) / Formers (100') aus einer Anzahl an Untermodellen besteht, die gleichzeitig gelöst werden, und wobei dazwischen Daten zwischen den Prozessoren, die verschiedene Untermodelle berechnen, in Abhängigkeit von den Lösungen der Untermodelle auf den neuesten Stand gebracht werden.

**14.** Verfahren gemäß einem der Ansprüche 1 bis 13,
**dadurch gekennzeichnet, dass**

das bei dem Verfahren erforderliche Berechnen verbessert wird, indem das Optimieren in Teile vorzugsweise so geteilt wird, dass die Regulierungsgrößen, die die größte Auswirkung auf die Qualität des fertigen Papiers (W) haben, häufiger optimiert werden, während sie auf die Änderungen schnell reagieren, wohingegen die anderen Parameter weniger häufiger optimiert werden, und dass für ein Optimieren der Regulationsgrößen, für die das gesamte Strömungsmodell nicht erforderlich ist, ein geeignetes Untermodell verwendet wird.

**15.** Verfahren gemäß einem der Ansprüche 1 bis 14,
**dadurch gekennzeichnet, dass**

die Mess- und Regulierungsgrößen des Stoffauflaufkastens (100), die zu regulieren sind, aus der folgenden Gruppe ausgewählt werden:

- Statischer Druck ($P_{in}$), Dichte ($C_{in}$) und Strömungsrate ($Q_{in}$) der Ganzstoffströmung in den Kopf (12);
- Geschwindigkeitsprofil ($U_{in}(x, z)$) der Strömung in den Kopf (12);
- Profil der Querschnittsfläche ($A_{in}(y)$) des Kopfes (12);
- Profile der Dichte und der Strömungsrate ($C(y)$, $Q_D(y)$) der Dilutionszufuhr (18);
- Druckverlustprofil ($\Delta p_t(y)$) des Turbolenzgenerators (15), Dichteprofil ($C_D(y)$), erzeugt durch Dilution an dem Auslassende des Turbolenzgenerators;
- Rezirkulationsströmungsrate ($Q_{rec}$) und Randzufuhrströmungsraten ($Q_{e1},Q_{e2}$) am vorderen Rand und hinteren Rand;
- gemessene / regulierte Form ($b(x,y)$) des Auslaufdüsenkanals (16) in der Maschinenrichtung ($x$) und in der Querrichtung ($y$);
- Geschwindigkeitskomponenten ($u(y)$, $v(y)$, $w(y)$) des Auslaufdüsenstrahls (J);
- Dichte ($c_{jet}(y)$), Dicke ($t_{jet}(y)$) und Turbolenzenergieprofile ($E_{jet}(y)$) des Auslaufdüsenstrahls (J);
- Gesamtströmungsrate ($Q_{jet,tot}$) des Auslaufdüsenstrahls (J).

**16.** Verfahren gemäß einem der Ansprüche 1 bis 15,
**dadurch gekennzeichnet, dass**

bei dem Verfahren sämtliche oder die wichtigsten Regulierungsparameter der Bahnbildungspartie als Gesamtregulierung reguliert werden, wie beispielsweise die Unterdruckhöhen der Formerwalzen, MB-Kästen, Formerschuhe und / oder Saugflachkästen; Positionen der Formerwalzen und / oder der Formerrippen und / oder Belastungskräfte und / oder Positionen der Wasserablaufelemente; Spannungen der Formersiebe; Retention und / oder Profilieren der Retention und / oder beliebige andere Parameter, die die Bahnbildung und das Ablaufen des Wassers, das aus der Bahn stattfindet, bei der Bahnbildungspartie beeinflussen.

**17.** Verfahren gemäß einem der Ansprüche 1 bis 17,
**dadurch gekennzeichnet, dass**

das Verfahren bei einer Papiermaschine in Verbindung mit der Änderung einer Papiersorte so angewendet wird, dass mittels des bei dem Verfahren anzuwendenden Modells neue optimale Regulierungswerte für die Papiersorte, die als nächstes laufen soll, vorhergesagt werden, wobei es der Zweck ist, die Zeitspanne zu verringern, die der Sortenwechsel einnimmt, und das Betriebszeitverhältnis der Papiermaschine zu erhöhen.


## Revendications

**1.** Procédé pour la régulation globale en continu d'une caisse de tête monocouche ou multicouche et/ou d'un formeur d'une machine de séchage de pâte à papier ou de carton ou de papier, comprenant les étapes consistant à :

(a) former un modèle d'écoulement de fluide physique de l'écoulement de suspension de la pâte à papier à réguler dans la caisse de tête (100)/formeur (100') ;
(b) résoudre le modèle d'écoulement pour obtenir un état d'écoulement simulé sur la base de données sur une géométrie de la caisse de tête (100)/formeur (100') et les conditions initiales et de limites liées à la caisse de tête (100)/formeur (100') ;
(c) obtenir un état d'écoulement cible sur la base d'exigences de qualité du papier produit à partir de l'écoulement de suspension de la pâte et des coûts de fonctionnement et d'exploitation de la machine à papier ;
(d) déterminer une différence entre l'état d'écoulement simulé et l'état d'écoulement cible, la différence constituant une fonction coût qui est composée au moins de profils cibles du papier fini (W), en particulier du poids de base et des profils d'orientation de fibres ou de valeurs calculées à partir de ces grandeurs ;
(e) optimiser la fonction coût et déterminer ensuite les valeurs de régulation optimales et les valeurs de consigne (C) pour les dispositifs d'instrumentation et les organes d'actionnement (105) de la caisse de tête (100) /formeur (100') qui affectent l'écoulement de suspension de la pâte dans la caisse de tête (100) et/ou le séchage et l'état d'écoulement de l'écoulement de suspension de pâte dans le formeur (100') au vu de la fonction coût ; et
(f) fournir les valeurs de régulation optimales et les valeurs de consigne (C) aux dispositifs de régulation de la caisse de tête (100)/formeur (100'), de telle sorte que les dispositifs de régulation de la caisse de tête (100) /formeur (100') fonctionnent aux valeurs de régulation optimales pour réaliser ainsi l'optimisation de la fonction coût.

**2.** Procédé selon la revendication 1, **caractérisé en ce que** le modèle d'écoulement de la caisse de tête et/ou du formeur est établi en s'appuyant sur les lois fondamentales de la dynamique des fluides, c'est-à-dire les lois de la conservation et des matières, ou à l'aide d'équations simplifiées dérivées desdites lois, et **en ce que** les équations sont résolues numériquement au moyen d'un ordinateur, et **en ce que** des mesures en ligne et/ou en laboratoire ainsi que des informations fournies par l'opérateur de la machine à papier sont utilisées comme valeurs initiales et de limites du modèle d'écoulement.

**3.** Procédé selon la revendication 1 ou 2, **caractérisé en ce qu'**au moyen d'un modèle physique, on calcule un nombre suffisamment élevé d'états d'écoulement et au moyen de ceux-ci un modèle statistique plus simple ou un réseau neuronal est adapté ou programmé pour illustrer l'état d'écoulement de la caisse de tête et/ou du formeur et/ou des dépendances de la fonction coût à partir des grandeurs de régulation, et ce modèle est utilisé pour l'optimisation.

**4.** Procédé selon l'une quelconque des revendications 1 à 3, **caractérisé en ce que** ledit modèle d'écoulement est résolu au moyen d'un ordinateur (140) d'une capacité de calcul élevée comprenant un ou plusieurs processeurs en utilisant des procédés numériques de solution, tels que les procédés d'éléments finis, de différences finies et de volumes finis en eux-mêmes connus ou des procédés équivalents.

5. Procédé selon l'une quelconque des revendications 1 à 4, **caractérisé en ce que** l'optimisation de ladite fonction coût et la régulation optimale sont effectuées selon l'algorithme suivant :

(a) le débit nécessaire, la qualité de matière et les données de géométrie de la caisse de tête (100)/formeur (100') sont lues et l'optimisation commence à partir des valeurs de régulation de défaut $\vec{\alpha}^{(i)}$,i=0, et la valeur $F^{(i)}$ de la fonction coût est calculée en résolvant le modèle d'écoulement de la caisse de tête (100)/formeur (100'),
(b) le gradient $\blacktriangledown F^{(i)}$ de la fonction coût avec les valeurs de régulation $\vec{\alpha}^{(i)}$ concernées est calculé,
(c) la direction $\vec{p}^{(i)}$ est déterminée au moyen du gradient $\blacktriangledown F^{(i)}$, laquelle direction précise dans gradient $\blacktriangledown F^{(i)}$, laquelle direction précise dans quelle direction les grandeurs de régulation doivent être changées pour abaisser la valeur de la fonction coût, par exemple $\vec{p}^{(i)} = -\nabla F^{(i)}$, c'est-à-dire le procédé de gradient ou tout autre procédé à base de gradient en lui-même connu, dans lequel la sensibilité de la fonction coût F en relation avec la quantité de régulation $\alpha_k$ est calculée au moyen du quotient de différence

$$\frac{\partial}{\partial_k} F = \frac{F(\alpha_k + \varepsilon) - F(\alpha_k)}{\varepsilon}$$

ou en résolvant l'équation d'état adjoint correspondant au modèle d'écoulement de la caisse de tête (100)/ formeur (100'),
(d) les nouvelles valeurs des grandeurs de régulation ($\vec{\alpha}^{(i+1)}$) sont déterminées en les faisant varier dans la direction déterminée dans l'étape précédente (c) de façon optimale

$$\vec{\alpha}^{(i+1)} = \vec{\alpha}^{(i)} + \lambda^{(i)} \vec{p}^{(i)},$$

auquel cas la longueur d'étape $\lambda^{(i)}$ est déterminée de telle sorte que la fonction coût reçoit une valeur inférieure à l'itération précédente, $F^{(i+1)} < F^{(i)}$, et les grandeurs de régulation ($\vec{\alpha}^{(i+1)}$) sont admissibles, et
(e) si la valeur de la fonction coût obtenue dans les étapes précédentes n'est pas encore suffisamment basse, on augmente un index pour est poursuivie à partir de l'étape ci-dessus (b), et dans le cas contraire, l'exécution de l'algorithme est interrompue et les valeurs des grandeurs de régulation (C) sont égalisées aux valeurs optimisées ($\vec{\alpha}^{(i+1)}$) et elles sont transmises aux dispositifs de régulation (105) de la caisse de tête (100)/formeur (100').

6. Procédé selon l'une quelconque des revendications 1 à 4, dans lequel l'optimum de la fonction coût est recherché au moyen d'un autre algorithme connu qui n'est pas basé sur le calcul du gradient de la fonction coût.

7. Procédé selon la revendication 1, **caractérisé en ce que**, en plus des profils cibles, ladite fonction coût comprend également des composantes liées à l'exploitation et/ou à la consommation d'énergie de la machine à papier.

8. Procédé selon l'une quelconque des revendications 1 à 7, **caractérisé en ce que**, dans le procédé, on choisit un certain niveau de qualité pour le papier fini (W) et, dans la caisse de tête (100), on recherche le débit global et la consommation d'énergie les plus faibles possibles, de préférence en réduisant le débit de recirculation ($Q_{rec}$) avec lequel ledit niveau de qualité est atteint et/ou, dans le formeur (100'), on recherche la consommation d'énergie la plus faible possible, de préférence en réduisant la consommation des jets d'eau et l'usure des toiles et des éléments de séchage de l'eau avec lesquels on atteint ledit niveau de qualité.

9. Procédé selon l'une quelconque des revendications 1 à 8, **caractérisé en ce que** l'on fixe différents poids pour différentes parties de la fonction coût, de préférence de telle sorte que la qualité du papier soit fixée comme la fonction la plus importante et que si l'exploitation peut être améliorée et/ou de l'énergie peut être économisée sans détériorer la qualité, celles-ci sont mises en oeuvre au moyen du procédé de l'invention.

10. Procédé selon l'une quelconque des revendications 1 à 9, **caractérisé en ce que** la fonction coût à optimiser est faite pour inclure des grandeurs de qualité qui sont dans la caisse de tête (100), exprimées au moyen du profil de vitesse et de la turbulence du jet de coupe (J), c'est-à-dire que le jet de coupe (J) déchargé de l'ouverture de coupe (17) de la caisse de tête est optimisé, et/ou qui sont dans le formeur (100') et sont exprimées au moyen des propriétés de la bande après le formeur.

**11.** Procédé selon l'une quelconque des revendications 1 à 10, **caractérisé en ce que**, lorsque le procédé est effectué, le calcul réalisé par l'ordinateur (140) est rendu plus rapide en effectuant le calcul en parallèle au moyen d'un ordinateur avec plusieurs processeurs ou au moyen d'ordinateurs, de préférence de telle sorte que les sensibilités des changements dans la fonction coût par rapport à différentes grandeurs de régulation sont calculées, respectivement au moyen d'un processeur spécifique.

**12.** Procédé selon la revendication 11, **caractérisé en ce que** les sensibilités de la fonction coût par rapport aux différentes grandeurs de régulation sont déterminées au moyen d'une analyse de sensibilité qui est effectuée dans un environnement de solution linéarisée, de telle sorte que le modèle d'écoulement est résolu au moyen d'une théorie de perturbation ou équivalente en déterminant le gradient de la fonction coût et pour l'optimisation, à d'autres égards, en utilisant un modèle non linéaire réel, auquel cas l'optimisation proprement dite repose sur un modèle d'écoulement réel et toute faute provenant de la théorie de perturbation ou équivalente n'a aucun effet sensible sur le résultat final de l'optimisation.

**13.** Procédé selon l'une quelconque des revendications 1 à 12, **caractérisé en ce que** le modèle d'écoulement de la caisse de tête (100)/formeur (100') est/sont constitué(s) d'un certain nombre de sous-modèles qui sont résolus en même temps et, dans l'intervalle, les données sont mises à jour entre les processeurs qui calculent différents sous-modèles en fonction des solutions des sous-modèles.

**14.** Procédé suivant l'une quelconque des revendications 1 à 13, **caractérisé en ce que** le calcul nécessaire dans le procédé est amélioré en divisant l'optimisation en parties, de préférence de telle sorte que les grandeurs de régulation qui ont la plus grande incidence sur la qualité du papier fini (W) sont optimisées plus fréquemment, tout en réagissant rapidement aux changements, tandis que les autres paramètres sont optimisés moins fréquemment et **en ce que**, pour optimiser les grandeurs de régulation pour lesquelles le modèle d'écoulement total n'est pas nécessaire, on utilise un sous-modèle approprié.

**15.** Procédé selon l'une quelconque des revendications 1 à 14, **caractérisé en ce que** la mesure et les grandeurs de régulation de la caisse de tête (100) à réguler sont choisies parmi le groupe suivant :

- pression statique ($P_{in}$), consistance ($C_{in}$) et débit ($Q_{in}$) de l'écoulement de matière dans le collecteur (12) ;
- profil de vitesse ($U_{in}(x,z)$) de l'écoulement dans le collecteur (12) ;
- profil de la section transversale ($A_{in}(y)$) du collecteur (12) ;
- profil de consistance et débit ($C(y),Q_D(y)$) de la charge de dilution (18) ;
- profil de perte de pression ($\Delta p_t(y)$) du générateur de turbulence (15), profil de consistance ($C_D(y)$) produit par dilution sur l'extrémité de sortie du générateur de turbulence ;
- débit de recirculation ($Q_{rec}$) et débit de charge de bord ($Q_{e1},Q_{e2}$) sur le bord avant et sur le bord arrière ;
- forme régulée/mesurée ($b(x,y)$) du canal de coupe (16) dans la machine (x) et direction transversale (y) ;
- composantes de vitesse ($u(y)$, $v(y)$, $w(y)$) du jet de coupe (J) ;
- consistance ($c_{jet}(y)$), épaisseur ($t_{jet}(y)$) et profils d'énergie-turbulence ($E_{jet}(y)$) du jet de coupe (J) ;
- débit global ($Q_{jet,tot}$) du jet de coupe (J).

**16.** Procédé selon l'une quelconque des revendications 1 à 15, **caractérisé en ce que**, dans le procédé, la totalité ou la plupart des paramètres importants parmi les paramètres de régulation de la section de formeur sont ajustés dans le cadre de la régulation globale, tels que les niveaux de vide des rouleaux de formage, les caisses MB, les sabots de formage et/ou les caisses plates d'aspiration ; les positions des rouleaux de formage et/ou des nervures de formage et/ou des forces de charge et/ou des positions des éléments de séchage d'eau ; les tensions des toiles de formage ; la rétention et/ou le profilage de rétention et/ou tout autre paramètre éventuel qui affectent la formation de la bande et l'égouttage de l'eau de la bande dans la section de formeur.

**17.** Procédé selon l'une quelconque des revendications 1 à 17, **caractérisé en ce que** le procédé est appliqué dans une machine à papier en liaison avec le changement de la qualité de papier, de telle sorte qu'au moyen du modèle à mettre en oeuvre dans le procédé, on anticipe les nouvelles valeurs de régulation optimales pour la qualité du papier qui doit être obtenue au cours du cycle de fabrication suivant, le but étant de réduire le temps consommé par le changement de qualité et d'accroître le rapport de temps de fonctionnement de la machine à papier.

FIG. 1

EP 0 837 966 B1

FIG. 2

FIG. 3

FIG. 4

FIG. 5

100 — HEADBOX

CONTROL ACTIONS
MEASUREMENTS

105 — HEADBOX INSTRUMENTATION

MEASUREMENTS
M

SUBCONTROLLER
SET-POINTS

125 — FIBER SUSPENSION PROPERTIES
- ONLINE/OFFLINE MEASUREMENTS

110 — STATUS OF JET IN MD, CD, Z
- VELOCITY PROFILES
- CONSISTENCY AND TURBULENCE PROFILES
- THICKNESS PROFILE

130 — SINGLE OR MULTIPROSESSOR COMPUTER / OPTIMAL CONTROLLER
140 — TOTAL FLOW FIELD OPTIMIZATION:
- HEADER / SLICE CHANNEL CONTROLS
- CONSISTENCY PROFILING
- PUMP AND VALVE CONTROLLER SET-POINTS
- OTHER ACTUATOR SET-POINTS
C

200 — PAPER MAKING PROCESS

PAPER
W

120 — PAPER QUALITY PROPERTIES AND PROFILES
- ONLINE/OFFLINE MEASUREMENTS

145 — TRANSFER MODEL
- FLOW FIELD TARGET
- PAPER QUALITY PREDICTION
SW

135 — OPERATOR CONTROL INTERFACE

INFORMATION & REPORTS:
- QUALITY AND COSTS
- PREDICTIONS BASED ON SIMULATION
ACCEPTANCE & CONTROL

155 — TARGETS:
- PAPER GRADE PROPERTIES
- PROFILE TARGETS
- PRODUCTION COSTS
- GRADE CHANGES

150 — RUNNABILITY, DIRTYING AND MALFUNCTIONING DIAGNOSTICS

FIG. 6

FIG. 7

EP 0 837 966 B1

The starting and default values $\vec{\alpha}^{(i)}$, the targets of optimizing, and the other necessary data are given, $i=0$

The sensitivity of the cost function in relation to the regulation quantities $\vec{\alpha}^{(i)}$ is computed

The direction $\vec{p}^{(i)}$ is determined in which the cost function becomes lower

Moving in the direction $\vec{p}^{(i)}$ until the values of the cost function start becoming higher: $\vec{\alpha}^{(i+1)} = \vec{\alpha}^{(i)} + \lambda^{(i)} \vec{p}^{(i)}$

Is the value of the cost function low enough?

Cost function or its change is too high

Cost function is low enough or does not become lower by changing the regulation quantities

Optimal regulation quantities $C = \vec{\alpha}^{(i+1)}$ have been found

Adjustments of the headbox are changed

## FIG. 8